# EUROPEAN PATENT SPECIFICATION

(11) **EP 3 162 167 B1**
(45) Date of publication and mention of the grant of the patent: **28.04.2021**
(21) Application number: 15735822.7
(22) Date of filing: 25.06.2015
(51) Int. Cl.: G01J 1/02, H05B 33/08, H01L 33/64, H05B 45/14, H05B 45/10, H05B 45/20, H05B 45/22, H05B 45/24

(54) **LED ILLUMINATION DEVICE AND METHOD FOR CALIBRATING AND CONTROLLING AN LED ILLUMINATION DEVICE OVER CHANGES IN TEMPERATURE, DRIVE CURRENT, AND TIME**
LED-BELEUCHTUNGSVORRICHTUNG UND VERFAHREN ZUR KALIBRIERUNG UND STEUERUNG EINER LED-BELEUCHTUNGSVORRICHTUNG ÜBER ÄNDERUNGEN BEI TEMPERATUR, ANTRIEBSSTROM UND ZEIT
DISPOSITIF D'ÉCLAIRAGE À DEL ET PROCÉDÉ D'ÉTALONNAGE ET DE COMMANDE D'UN DISPOSITIF D'ÉCLAIRAGE À DEL EN PRÉSENCE DE VARIATIONS DE TEMPÉRATURE, DE COURANT D'EXCITATION ET DE TEMPS

(30) Priority: 25.06.2014 US 201414314451; 25.06.2014 US 201414314482; 25.06.2014 US 201414314530; 25.06.2014 US 201414314556; 25.06.2014 US 201414314580
(43) Date of publication of application: 03.05.2017
(60) Divisional application: 21164364.8
(73) Proprietor: Lutron Ketra, LLC, Coopersburg, PA 18036 (US)
(72) Inventor: HO, Horace, C., Austin, Texas 78726 (US); LEWIS, Jason, E., Driftwood, Texas 78619 (US); KNAPP, David, J., Austin, TX 78704 (US); SAVAGE, Joseph, A., Cedar Park, Texas 78613 (US); CHANG, Kuo-Lih, Austin, Texas 78738 (US); MALONE, Mickey, Paige, Texas 78659 (US)
(74) Representative: AWA Sweden AB
(86) International application number: PCT/US2015/037660
(87) International publication number: WO 2015/200615

(56) References cited:
- WO-A1-2013/041109
- US-A1- 2012 056 545

## Description

### BACKGROUND OF THE INVENTION

### 1. Field of the Invention

This invention relates to illumination devices comprising a plurality of light emitting diodes (LEDs) and, more particularly, to illumination devices and methods for calibrating and controlling individual LEDs in the illumination device, so as to obtain a desired luminous flux and a desired chromaticity of the device over changes in drive current, temperature, and over time as the LEDs age. An illumination device is also provided herein comprising one or more emitter modules having improved thermal and electrical characteristics.

### 2. Description of the Relevant Art

The following descriptions and examples are provided as background only and are intended to reveal information that is believed to be of possible relevance to the present invention. No admission is necessarily intended, or should be construed, that any of the following information constitutes prior art impacting the patentable character of the subject matter claimed herein.

Lamps and displays using LEDs (light emitting diodes) for illumination are becoming increasingly popular in many different markets. LEDs provide a number of advantages over traditional light sources, such as incandescent and fluorescent light bulbs, including low power consumption, long lifetime, no hazardous materials, and additional specific advantages for different applications. When used for general illumination, LEDs provide the opportunity to adjust the color (e.g., from white, to blue, to green, etc.) or the color temperature (e.g., from "warm white" to "cool white") to produce different lighting effects.

Although LEDs have many advantages over conventional light sources, one disadvantage of LEDs is that their output characteristics (e.g., luminous flux and chromaticity) vary over changes in drive current, temperature and over time as the LEDs age. These effects are particularly evident in multi-colored LED illumination devices, which combine a number of differently colored emission LEDs into a single package.

An example of a multi-colored LED illumination device is one in which two or more different colors of LEDs are combined within the same package to produce white or near-white light. There are many different types of white light lamps on the market, some of which combine red, green and blue (RGB) LEDs, red, green, blue and yellow (RGBY) LEDs, phosphor-converted white and red (WR) LEDs, RGBW LEDs, etc. By combining different colors of LEDs within the same package, and driving the differently colored LEDs with different drive currents, these lamps may be configured to generate white or near-white light within a wide gamut of color points or correlated color temperatures (CCTs) ranging from "warm white" (e.g., roughly 2600K-3700K), to "neutral white" (e.g., 3700K-5000K) to "cool white" (e.g., 5000K-8300K). Some multi-colored LED illumination devices also enable the brightness and/or color of the illumination to be changed to a particular set point. These tunable illumination devices should all produce the same color and color rendering index (CRI) when set to a particular dimming level and chromaticity setting (or color set point) on a standardized chromacity diagram.

A chromaticity diagram maps the gamut of colors the human eye can perceive in terms of chromacity coordinates and spectral wavelengths. The spectral wavelengths of all saturated colors are distributed around the edge of an outlined space (called the "gamut" of human vision), which encompasses all of the hues perceived by the human eye. The curved edge of the gamut is called the spectral locus and corresponds to monochromatic light, with each point representing a pure hue of a single wavelength. The straight edge on the lower part of the gamut is called the line of purples. These colors, although they are on the border of the gamut, have no counterpart in monochromatic light. Less saturated colors appear in the interior of the figure, with white and near-white colors near the center.

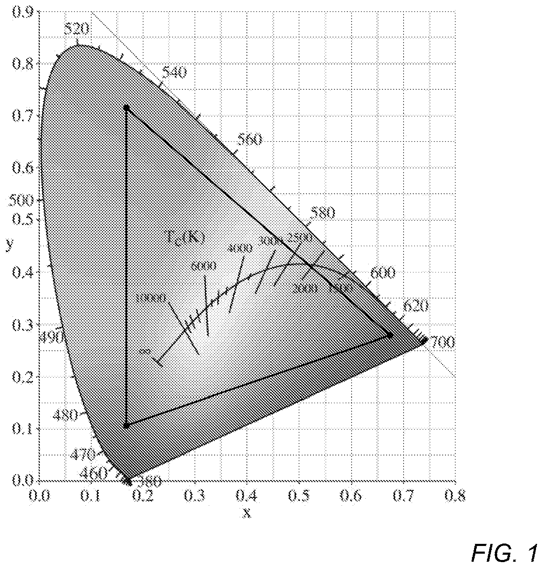

In the 1931 CIE Chromaticity Diagram, colors within the gamut of human vision are mapped in terms of chromaticity coordinates (x, y). For example, a red (R) LED with a peak wavelength of 625 nm may have a chromaticity coordinate of (0.69, 0.31), a green (G) LED with a peak wavelength of 528 nm may have a chromaticity coordinate of (0.18, 0.73), and a blue (B) LED with a peak wavelength of 460 nm may have a chromaticity coordinate of (0.14, 0.04). The chromaticity coordinates (i.e., color points) that lie along the blackbody locus obey Planck's equation, E(λ)=Aλ⁻⁵/(e^{(B/T)}-1). Color points that lie on or near the blackbody locus provide a range of white or near-white light with color temperatures ranging between approximately 2500K and 10,000K. These color points are typically achieved by mixing light from two or more differently colored LEDs. For example, light emitted from the RGB LEDs shown in Fig. 1 may be mixed to produce a substantially white light with a color temperature in the range of about 2500K to about 5000K.

Although an illumination device is typically configured to produce a range of white or near-white color temperatures arranged along the blackbody curve (e.g., about 2500K to 5000K), some illumination devices may be configured to produce any color within the color gamut 18 (triangle) formed by the individual LEDs (e.g., RGB). The chromaticity coordinates of the combined light, e.g., (0.437, 0.404) for 3000K white light, define the target chromaticity or color set point at which the device is intended to operate. In some devices, the target chromaticity or color set point may be changed by altering the ratio of drive currents supplied to the individual LEDs.

In general, the target chromaticity of the illumination device may be changed by adjusting the drive current levels (in current dimming) or duty cycle (in PWM dimming) supplied to one or more of the emission LEDs. For example, an illumination device comprising RGB LEDs may be configured to produce "warmer" white light by increasing the drive current supplied to the red LEDs and decreasing the drive currents supplied to the blue and/or green LEDs. Since adjusting the drive currents also affects the lumen output and temperature of the illumination device, the target chromaticity must be carefully calibrated and controlled to ensure that the actual chromaticity equals the target value. Most prior art illumination devices fail to provide an accurate calibration and compensation method for controlling the color of the illumination device.

Some prior art illumination devices also provide dimming capabilities, i.e., the ability to change the brightness or luminous flux output from the emission LEDs, in addition to (or instead of) color tuning. In most cases, the dimming level is changed by adjusting the drive current levels (in current dimming) or the duty cycle of the drive currents (in PWM dimming) supplied to all emission LEDs to produce a target dimming level. However, adjusting the supplied drive currents changes the chromaticity of the illumination, and this change in chromaticity differs for different LED devices and different dimming methods. For example, the chromaticity of an RGB LED illumination device may change rather significantly with changes drive current level and duty cycle, while the chromaticity of a phosphor-converted white LED illumination device is more consistent. In order to maintain a consistent target chromaticity, a range of target chromaticity values must be carefully calibrated over a range of target dimming levels.

In practice, the lumen output and chromaticity produced by prior art illumination devices often differs from the target dimming level and target chromaticity setting, due to changes in temperature and over time as the LEDs age. In general, changes in temperature affect the lumen output and chromaticity of all phosphor converted and non-phosphor converted LEDs. While prior art devices may perform some level of temperature compensation, they fail to provide accurate results by failing to recognize that temperature affects the lumen output and chromaticity of different colors of LEDs differently. Moreover, these prior art devices fail to account for chromaticity shifts in the illumination produced by phosphor converted LEDs, which result from phosphor aging. As a consequence, these prior art devices cannot maintain a desired luminous flux and a desired chromaticity for an LED illumination device over operating conditions and over the lifetime of the illumination device.

A need remains for improved illumination devices and methods for calibrating and compensating individual LEDs within an LED illumination device, so as to accurately maintain a desired luminous flux and a desired chromaticity for the illumination device over changes in temperature, changes in drive current and over time, as the LEDs age. This need is particularly warranted in multi-color LED illumination devices, since different colors of LEDs are affected differently by temperature and age, and in tunable illumination devices that enable the target dimming level and/or the target chromaticity setting to be changed by adjusting the drive currents supplied to one or more of the LEDs, since changes in drive current inherently affect the lumen output, color, and temperature of the illumination device. An example of a circuit for and a method of sensing a property of light can be found in US 2012/0056545 and an example of a method of controlling an illumination device based on a current-voltage model can be found in WO2013/041109. The subject matter of the claims set forth inventions disclosed herein.

### SUMMARY OF THE INVENTION

A method is provided herein for calibrating an illumination device comprising a first light emitting diode - hereinafter abbreviated LED - and a photodetector, the method comprising:
subjecting the illumination device to a first ambient temperature; successively applying at least three different drive currents to the first LED to produce illumination at three or more different levels of brightness; obtaining a plurality of optical measurements from the illumination produced by the first LED at each of the at least three different drive currents, wherein the plurality of optical measurements comprise luminous flux and chromaticity;obtaining a plurality of electrical measurements from the photodetector, wherein the plurality of electrical measurements comprise a plurality of photocurrents, which are induced on the photodetector by the illumination produced by the first LED at each of the at least three different drive currents, and forward voltages that are measured across the photodetector before, during or after each induced photocurrent is measured; and storing the plurality of optical measurements resulting from the step of obtaining a plurality of optical measurements and the plurality of electrical measurements resulting from the step of obtaining a plurality of electrical measurements within the illumination device to calibrate the first LED at the first ambient temperature.

The forward voltages may be measured across the photodetector by applying a non-operative drive current to the photodetector. The non-operative drive current applied to the photodetector for measuring forward voltages may range between approximately 100 µA and approximately 1mA, depending on the number of photodetectors included within the illumination device, the size of the photodetector(s) and the manner in which they are connected.

The calibration method may also measure a forward voltage that develops across the anode and cathode of the first LED by applying a non-operative drive current to the first LED sometime before, during or after each induced photocurrent is measured from the photodetector. The non-operative drive current applied to the first LED for measuring forward voltage may range between approximately 1 mA and approximately 10 mA, depending on the size of the first LED.

Sometime after the optical and electrical measurement values are obtained at the first ambient temperature, the results of the obtaining steps may be stored within the illumination device to calibrate the first LED at the first temperature. In , an example useful for understanding the invention the optical and electrical measurement values obtained at the first ambient temperature may be stored within a table of calibration values.

In some cases, the calibration method may continue by subjecting the illumination device to a second ambient temperature, which is different from the first ambient temperature, and repeating the steps of successively applying at least three different drive currents to the first LED, obtaining a plurality of optical measurements from the illumination produced by the first LED at each of the at least three different drive currents, obtaining a plurality of electrical measurements from the photodetector, and storing the results of the obtaining steps within the illumination device to calibrate the first LED at the second ambient temperature. The optical and electrical measurement values obtained at the second ambient temperature may also be stored.

The illumination device a may comprise plurality of light emitting diode (LED) chains, which are configured to produce illumination for the illumination device and a photodetector, which is configured for detecting the illumination produced by each of the plurality of LED chains. In general, each LED chain may include one or more LEDs of the same color. In some embodiments, each LED chain may be configured for producing illumination with a different peak emission wavelength. In other embodiments, two or more LED chains may be configured for producing illumination with the same peak emission wavelength.

The illumination device may further comprise an LED driver and receiver circuit, which is configured for successively applying at least three different drive currents to each of the LED chains, one LED chain at a time, to produce illumination at different levels of brightness when the LED chains are subjected to a first ambient temperature, measuring photocurrents induced on the photodetector by the illumination produced by each of the LED chains at each of the at least three different drive currents, and measuring forward voltages that develop across the photodetector before, during or after each induced photocurrent is measured. In addition, the LED driver and receiver circuit is also configured for repeating the steps of successively applying at least three different drive currents to each of the LED chains, measuring photocurrents induced on the photodetector, and measuring forward voltages that develop across the photodetector when the LED chains are subjected to a second ambient temperature, which is different from the first ambient temperature.

In the example useful for understanding the invention the illumination device may further comprise an interface that is configured for receiving luminous flux and chromaticity measurements, which are measured by an external calibration tool upon receiving the illumination produced by each of the LED chains at each of the at least three different drive currents when the LED chains are subjected to the first and second ambient temperatures. The interface may be a wireless interface configured to communicate using radio frequency (RF), infrared (IR) light or visible light. For example, the wireless interface may be configured to operate according to at least one of the ZigBee, WiFi, or Bluetooth communication protocols. The interface may be a wired interface, which is configured to communicate over an AC mains, a dedicated conductor or a set of conductors.

In an example useful for understanding the invention the illumination device may further comprise a storage medium, which is configured for storing the photocurrent, forward voltage, luminous flux, and chromaticity measurements obtained for each of the LED chains within a table of calibration values. The photocurrent, forward voltage, luminous flux, and chromaticity measurements stored within the storage medium may comprise measured values, which are obtained from the LED driver and receiver circuit and the external calibration tool. The measured values may be used to calculate calibration coefficients, which are stored within the storage medium in addition to, or in lieu of, the received calibration values.

According to an example useful for understanding the invention, the table of calibration values may include, for each LED chain, a first plurality of photocurrent values obtained from the photodetector upon receiving illumination from the LED chain when the LED chain is subjected to the first ambient temperature and the at least three different drive currents are successively applied to the LED chain, a second plurality of photocurrent values obtained from the photodetector upon receiving illumination from the LED chain when the LED chain is subjected to the second ambient temperature and the at least three different drive currents are successively applied to the LED chain, and a plurality of forward voltage values measured across the photodetector before, during or after each photocurrent value is measured.

In an example useful for understanding the invention, the LED driver and receiver circuit may be further configured for applying a non-operative drive current to each LED chain and for measuring a forward voltage that develops across each LED chain before, during or after each induced photocurrent is measured. In such embodiments, the table of calibration values may include, for each LED chain, a first plurality of forward voltage values measured across the LED chain upon applying the non-operative drive current to the LED chain when the LED chain is subjected to the first ambient temperature, and a second plurality of forward voltage values measured across the LED chain upon applying the non-operative drive current to the LED chain when the LED chain is subjected to the second ambient temperature.

In an example useful for understanding the invention, the table of calibration values may further include, for each LED chain, a first plurality of luminous flux values detected from the LED chain upon applying the at least three different drive currents to the LED chain when the LED chain is subjected to the first ambient temperature, and a second plurality of luminous flux values detected from the LED chain upon applying the at least three different drive currents to the LED chain when the LED chain is subjected to the second ambient temperature.

In an example useful for understanding the invention, the table of calibration values may further include, for each LED chain, a first plurality of x chromaticity values and a first plurality of y chromaticity values, which are detected from the LED chain upon applying the at least three different drive currents to the LED chain when the LED chain is subjected to the first ambient temperature, and a second plurality of x chromaticity values and a second plurality of y chromaticity values, which are detected from the LED chain upon applying the at least three different drive currents to the LED chain when the LED chain is subjected to the second ambient temperature. However, the table of calibration values is not limited to storing chromaticity vales from only the CIE 1931 XYZ color space, and may additionally or alternatively store chromaticity values from any color space that can be used to describe the gamut of an LED illumination device comprising combinations of emission LEDs as described herein.

In an example useful for understanding the invention, the illumination device may comprise an additional photodetector, which is configured for detecting the illumination produced by a subset of the plurality of LED chains. In one example, the subset of LED chains may comprise a chain of phosphor converted LEDs (e.g., a chain of phosphor converted white LEDs) and a chain of reference LEDs (e.g., a chain of blue LEDs)

In an example useful for understanding the invention, the LED driver and receiver circuit may be further configured for measuring photocurrents induced on the additional photodetector by the illumination individually produced by the chain of phosphor converted LEDs and the chain of reference LEDs at each of the at least three different drive currents when the LED chains are subjected to the first and second ambient temperatures, and measuring forward voltages that develop across the additional photodetector before, during or after each induced photocurrent is measured.

In an example useful for understanding the invention, the table of calibration values may further include, for each LED chain within the subset, a first plurality of photocurrent values obtained from the additional photodetector upon receiving illumination from the LED chain when the LED chain is subjected to the first ambient temperature and the at least three different drive currents are successively applied to the LED chain, a second plurality of photocurrent values obtained from the additional photodetector upon receiving illumination from the LED chain when the LED chain is subjected to the second ambient temperature and the at least three different drive currents are successively applied to the LED chain, and a plurality of forward voltage values measured across the additional photodetector before, during, or after each photocurrent value is measured. The induced photocurrents and forward voltages measured across the additional photodetector may be stored within the storage medium as measured values or calculated coefficients.

In an example useful for understanding the invention, an illumination device is provided herein with a plurality of light emitting diode (LED) chains, an LED driver and receiver circuit, a photodetector, a storage medium and a control circuit. The plurality of light emitting diode (LED) chains may be generally configured to produce illumination for the illumination device. The photodetector may be generally configured for detecting the illumination produced by the plurality of LED chains. The storage medium may be generally configured for storing a table of calibration values correlating forward voltages and photocurrents that were previously measured from the photodetector to drive currents that were previously applied to each of the LED chains at a plurality of different temperatures during calibration of the illumination device.

The LED driver and receiver circuit may be generally configured for applying drive currents to the plurality of LED chains substantially continuously to produce the illumination. In addition, the LED driver and receiver circuit may be further configured for measuring a photocurrent induced on the photodetector in response to the illumination produced by each LED chain, one LED chain at a time, and received by the photodetector, measuring a forward voltage developed across the photodetector to provide a current measurement of temperature, and supplying the measured photocurrents and the measured forward voltage to the control circuit.

The control circuit may be coupled to the LED driver and receiver circuit, the photodetector and the storage medium, and may be generally configured for determining an expected photocurrent value for each LED chain from the stored table of calibration values using the current measurement of temperature and the drive currents currently applied to each LED chain. In addition, the control circuit may be further configured for adjusting the drive current currently applied by the LED driver and receiver circuit to each LED chain to produce illumination, if the expected photocurrent value determined by the control circuit for the LED chain differs from the photocurrent measured by the LED driver and receiver circuit for the LED chain. For each LED chain, for example, the control circuit may be configured for calculating a scale factor by dividing the expected photocurrent value by the photocurrent measured by the LED driver and receiver circuit, applying the scale factor to a desired luminous flux value to obtain an adjusted luminous flux value, and adjusting the drive current currently applied to the LED chain to achieve the adjusted luminous flux value.

In an example useful for understanding the invention, the control circuit may be configured for determining the expected photocurrent value for each LED chain by using the forward voltage measured by the LED driver and receiver circuit, the drive current currently applied by the LED driver and receiver circuit to the LED chain to produce illumination, the table of calibration values and one or more interpolation techniques.

For example, the table of calibration values may include, for each LED chain, a first plurality of stored photocurrent values, a second plurality of stored photocurrent values, and a plurality of stored forward voltage values. The first plurality of stored photocurrent values may be ones, which were previously obtained from the photodetector upon receiving illumination from the LED chain when the LED chain was subjected to a first temperature and a plurality of drive currents were successively applied to the LED chain. The second plurality of stored photocurrent values may be ones, which were previously obtained from the photodetector upon receiving illumination from the LED chain when the LED chain was subjected to a second temperature and the plurality of drive currents were successively applied to the LED chain. The plurality of stored forward voltage values may be ones, which were previously measured across the photodetector before, during or after each of the first and second plurality of photocurrents were obtained. The first plurality of stored photocurrent values, the second plurality of stored photocurrent values and the plurality of stored forward voltage values may comprise measured values. The measured values may be used to calculate calibration coefficients, which are stored within the table of calibration values in addition to, or in lieu of, the measured values.

In an example useful for understanding the invention, the control circuit may be configured for determining the expected photocurrent value for each LED chain by calculating a third plurality of photocurrent values corresponding to the forward voltage measured by the LED driver and receiver circuit by interpolating between the first plurality of stored photocurrent values and the second plurality of stored photocurrent values corresponding to the LED chain, generating a relationship between the third plurality of photocurrent values, and selecting the expected photocurrent value from the generated relationship that corresponds to the drive current currently applied by the LED driver and receiver circuit to the LED chain. In some cases, the control circuit may be configured to calculate the third plurality of photocurrent values by using a non-linear interpolation technique to interpolate between the first and second plurality of stored photocurrent values. In some cases, the control circuit may be configured to generate the relationship by applying a higher-order interpolation to the third plurality of photocurrent values to generate a non-linear relationship between photocurrent and drive current for the LED chain. In other cases, the control circuit may be configured to generate the relationship by applying a piece-wise linear interpolation to the third plurality of photocurrent values to approximate a non-linear relationship between photocurrent and drive current for the LED chain.

The illumination devices and methods described above are generally suitable for calibrating and controlling an LED illumination device comprising non-phosphor converted LEDs. In addition to those described above, illumination devices and methods are also provided herein for calibrating and controlling an LED illumination device comprising at least one phosphor converted LED. One example of a phosphor converted LED is a phosphor converted white LED, which is formed by coating or covering, e.g., a blue LED having a peak emission wavelength of about 400-500 with a phosphor material (e.g., YAG) to produce substantially white light with a Color Correlated Temperature (CCT) of about 3000K. Other combinations of LEDs and phosphors may be used to form a phosphor converted white LED, which is capable of producing white or near-white light with a CCT in the range of about 2700K to about 10,000k.

In phosphor converted white LEDs, the spectral content of the LED combines with the spectral content of the phosphor to produce white or near-white light. The combined spectrum may include a first portion having a first peak emission wavelength (e.g., about 400-500), and a second portion having a second peak emission wavelength (e.g., about 500-650), which is substantially different from the first peak emission wavelength. In this example, the first portion of the spectrum is generated by the light emitted by the blue LED, and the second portion is generated by the light that passes through the phosphor (e.g., YAG).

As the phosphor converted white LED ages, the efficiency of the phosphor decreases, which causes the chromaticity of the phosphor converted white LED to appear "cooler" over time. In order to account for age-related chromaticity shifts in a phosphor converted LED, the illumination device described herein may include two different photodetectors for separately measuring the photocurrents induced by the LED portion and the photocurrents induced by the phosphor portion of the phosphor converted LED. In one exemplary embodiment, the illumination device may include a first photodetector whose detection range is configured for detecting only the first portion of the spectrum emitted by the phosphor converted LED, and a second photodetector whose detection range is configured for detecting only the second portion of the spectrum emitted by the phosphor converted LED.

In general, the detection range of the first and second photodetectors may be selected based on the spectrum of the phosphor converted LED being measured. In the exemplary embodiment described above, in which a phosphor converted white LED is included within the illumination device and implemented as described above, the detection range of the first photodetector may range between about 400nm and about 500nm for measuring the photocurrents induced by light emitted by the blue LED portion, and the detection range of the second photodetector may range between about 500nm and about 650nm for measuring the photocurrents induced by light that passes through the phosphor portion of the phosphor converted white LED. The first and second photodetectors may include dedicated photodetectors and/or emission LEDs, which are sometimes configured for detecting incident light.

In an example useful for understanding the invention, the illumination device may also include a reference LED (e.g., a blue emission LED) having a peak emission wavelength, which falls within the first portion of the spectrum emitted by the phosphor converted LED. If such a reference LED is included, the photocurrents induced by the illumination produced by the reference LED on the first and second photodetectors may be used, in some embodiments, to account for detector aging when adjusting the chromaticity of the phosphor converted white LED.

In an example useful for understanding the invention, the illumination device may include other emission LEDs in addition to the phosphor converted LED and the optional reference LED (which may also be an emission LED). In addition to emission LEDs and photodetectors, the illumination device described herein may also generally include an LED driver and receiver circuit, a storage medium and a control circuit. Other components not specifically mentioned herein may also be included.

During a calibration phase, the LED driver and receiver circuit successively applies a plurality of different drive currents to the phosphor converted LED and the reference LED, one LED at a time, to produce illumination at different levels of brightness when the illumination device is subjected to a first ambient temperature. At each of the different drive currents, the LED driver and receiver circuit measures photocurrents, which are induced on the first and second photodetectors by the illumination produced by the phosphor converted LED, and measures forward voltages that develop across the first and second photodetectors before, during or after each induced photocurrent is measured. Once the induced photocurrents and forward voltage measurements are obtained, the LED driver and receiver circuit repeats the steps of successively applying a plurality of different drive currents to the phosphor converted LED, measuring photocurrents induced on the first and second photodetectors, and measuring forward voltages that develop across the first and second photodetectors when the illumination device is subjected to a second ambient temperature, which is different from the first ambient temperature. In an example useful for understanding the invention, the LED driver and receiver circuit may also measure the photocurrents, which are induced on the first and second photodetectors by the illumination by reference LED, at each of the different drive currents and each of the first and second ambient temperatures. The photocurrent and forward voltage measurements obtained by the LED driver and receiver circuit during the calibration phase may be stored within a table of calibration values within a storage medium of the illumination device.

During operation of the illumination device, the LED driver and receiver circuit may be configured for applying drive currents to the phosphor converted LED substantially continuously to produce illumination, and for measuring photocurrents induced on the first and second photodetectors in response to the illumination, which is produced by the phosphor converted LED, and received by the first and second photodetectors. In particular, the LED driver and receiver circuit may measure a first photocurrent induced on the first photodetector and a second photocurrent induced on the second photodetector in response to the illumination produced by the phosphor converted LED. The first photocurrent may correspond to the first portion of the spectrum of the phosphor converted LED, and the second photocurrent may correspond to the second portion of the spectrum of the phosphor converted LED. In an example useful for understanding the invention, the LED driver and receiver circuit may also measure a third photocurrent induced on the first photodetector and a fourth photocurrent induced on the second photodetector in response to the illumination produced by reference LED. In addition to induced photocurrents, the LED driver and receiver circuit may measure the forward voltages that develop across the first and second photodetectors before, during or after the induced photocurrents are measured.

The control circuit may be coupled to the LED driver and receiver circuit, the first and second photodetectors and the storage medium, and may be generally configured for determining expected photocurrent values for the phosphor converted LED from the table of calibration values using the forward voltages measured by the LED driver and receiver circuit during operation of the illumination device and the drive currents currently applied to the phosphor converted LED and the reference LED to produce illumination. In addition, the control circuit may be configured for adjusting the drive currents currently applied by the LED driver and receiver circuit to the phosphor converted LED to produce illumination, if the expected photocurrent values determined by the control circuit for the phosphor converted LED differ from the photocurrents measured by the LED driver and receiver circuit for the phosphor converted LED.

As noted above, methods are also provided herein for calibrating and controlling an illumination device comprising a phosphor converted LED and at least two different photodetectors. According to one embodiment, the calibration method used for calibrating an illumination device comprising a phosphor converted LED and at least two different photodetectors begins by successively applying at least three different drive currents to the phosphor converted LED to produce illumination at different levels of brightness upon subjecting the phosphor converted LED to a first ambient temperature. At each of the at least three different drive currents, the calibration method measures the photocurrents, which are induced on the first and second photodetectors by the illumination produced by the phosphor converted LED, and the forward voltages that develop across the first and second photodetectors before or after each induced photocurrent is measured. The results of the measuring steps are stored within the illumination device to calibrate the phosphor converted LED at the first ambient temperature. In an example useful for understanding the invention

In an example useful for understanding the invention, the photocurrents induced on the first photodetector by the illumination produced by the phosphor converted LED may correspond to a first portion of a spectrum of the phosphor converted LED, wherein the first portion (e.g., an LED portion) has a first peak emission wavelength (e.g., about 400nm to about 500nm). The photocurrents induced on the second photodetector by the illumination produced by the phosphor converted LED may correspond to a second portion of the spectrum of the phosphor converted LED, wherein the second portion (e.g., a phosphor portion) has a second peak emission wavelength (e.g., about 500nm to about 650nm), which is substantially different from the first peak emission wavelength. By separately measuring the photocurrents induced on the first and second photodetectors by the illumination produced by the phosphor converted LED, and storing these values within the illumination device, the calibration method enables different portions of the phosphor converted LED spectrum to be calibrated separately, as if the phosphor converted LED were two separate LEDs.

In an example useful for understanding the invention, the calibration method may also obtain separate luminous flux and chromaticity measurements for the first portion and the second portion of the phosphor converted LED spectrum at each of the at least three different drive currents. By separately measuring the luminous flux and chromaticity attributed to each portion of the phosphor converted LED spectrum at each of the at least three different drive currents, and storing these values within the illumination device, the calibration method enables different portions of the phosphor converted LED spectrum to be calibrated separately, as if the phosphor converted LED were two separate LEDs.

Once the calibration values described above are obtained for the first ambient temperature, the calibration method may repeat the steps of successively applying at least three different drive currents, measuring photocurrents induced on the first and second photodetectors, and measuring forward voltages that develop across the first and second photodetectors upon subjecting the illumination device to a second ambient temperature, which is substantially different from the first ambient temperature. In an example useful for understanding the invention, the luminous flux chromaticity attributed to each portion of the phosphor converted LED spectrum may also be obtained at the second temperature for each of the at least three different drive currents. The results of the measuring steps may be stored within the illumination device to calibrate the an example useful for understanding the invention phosphor converted LED at the second ambient temperature. In an example useful for understanding the invention, the calibration method may be performed for a reference LED having a peak emission wavelength that falls within the first portion of the spectrum of the phosphor converted LED.

Various example useful for understanding the invention of improved emitter modules for a light emitting diode (LED) illumination device are also provided herein. In general, the improved emitter modules disclosed herein may utilize a single layer substrate or a multiple layer substrate, which is designed to improve thermal separation between the emission LEDs, and between the emission LEDs and the photodetectors, while also providing good thermal conductivity to the heat sink. The multiple layer substrate further includes multiple routing and dielectric layers, which provides enhanced routing flexibility for connecting chains of the emission LEDs together, and electrically isolates the emission LEDs and photodetectors from the heat sink.

According to an example useful for understanding the invention, an illumination device is provided herein comprising one or more emitter modules, wherein each emitter module generally includes a plurality of emission LEDs configured for producing illumination for the illumination device, and one or more photodetectors configured for detecting the illumination produced by the plurality of LEDs. In general, the plurality of LEDs and the one or more photodetectors are mounted upon a substrate and encapsulated within a primary optics structure. A heat sink is coupled to a bottom surface of the substrate for dissipating heat generated by the emitter module.

In an example useful for understanding the invention emitter module may include substantially any number and color of emission LEDs and substantially any number and color of photodetectors. The emission LEDs include one or more red LEDs, one or more blue LEDs, one or more green LEDs and one or more white or yellow LEDs. The emission LEDs may generally be arranged in an array near the center of the primary optics structure, and the one or more photodetectors may generally be arranged about a periphery of the array. The one or more photodetectors may include one or more red, orange, yellow and/or green LEDs. In some embodiments, the one or more photodetectors may be omitted if one or more of the emission LEDs are configured, at times, for detecting incident light.

In an example useful for understanding the invention the primary optics structure may be formed from a variety of different materials and may have substantially any shape and/or dimensions necessary to shape the light emitted by the emission LEDs in a desirable manner. The primary optics structure may have a dome shape. However, one skilled in the art would understand how the primary optics structure may have substantially any other shape or configuration, which encapsulates the emission LEDs and the one or more photodetectors. The shape, size and material of the dome may be generally designed to improve optical efficiency and color mixing within the emitter module.

The heat sink is coupled to a bottom surface of the substrate for drawing heat away from the heat generating components of the emitter module. In general, the heat sink may comprise substantially any material with relatively high thermal and electrical conductivity. In some embodiments, the heat sink is formed from a material having a thermal conductivity that ranges between about 200 W/(mK) and about 400 W/(mK). In one embodiment, the heat sink is formed from a copper or copper-alloy material, or an aluminum or aluminum alloy material. In some embodiments, the heat sink may be a relatively thick layer ranging between about 1 mm and about 10 mm, and in one embodiment, may be about 3 mm thick.

The substrate is generally configured to provide a relatively high thermal impedance in the lateral direction, and a relatively low thermal impedance in the vertical direction. In an example useful for understanding the invention, the substrate is formed so as to include only a single layer of material. In order to provide the relatively high thermal impedance in the lateral direction, the single layer substrate may be formed from a material having a relatively high thermal impedance, or a relatively low thermal conductivity. In one example, the substrate may be formed from a material (e.g., aluminum nitride) having a thermal conductivity less than about 150 W/(mK), a material (e.g., aluminum oxide) having a thermal conductivity less than about 30 W/(mK), or a material (e.g., a PTFE or other laminate material) having a thermal conductivity less than about 1 W/(mK).

In general, the single layer substrate may provide the relatively low thermal impedance in the vertical direction by providing a relatively low thermal impedance path between each of the emission LEDs and each of the one or more photodetectors to the heat sink. In an example useful for understanding the invention, the low thermal impedance paths may be implemented by minimizing a thickness of the substrate, and connecting each of the LEDs and each of the one or more photodetectors to the heat sink with a plurality of thermally conductive lines. For example, a thickness of the substrate may range between about 300µm and about 500 µm.

The plurality of thermally conductive lines may comprise substantially any thermally conductive material. In some embodiments, the thermally conductive lines may be formed from a material having a thermal conductivity that ranges between about 200 W/(mK) and about 400 W/(mK). The material used for the thermally conductive lines may be the same material used for the heat sink, or may be different. In an example useful for understanding the invention, the thermally conductive lines are formed from an aluminum, aluminum-alloy, copper or copper-alloy material. The plurality of thermally conductive lines may be formed by drilling vertical holes through the substrate (using any mechanical or optical means), and filling or plating the holes (or vias) with a metal material using any appropriate method. In some embodiments, each thermally conductive line may comprise a plurality (e.g., about 10-20) of densely packed vias, with each via being only a couple of hundred microns wide.

While the single layer substrate provides desirable thermal characteristics (e.g., good thermal separation between emission LEDs and between emission LEDs and photodetectors, and good thermal conductivity to the heat sink), it may not provide the electrical characteristics that are desired in some emitter modules. In order to provide improve routing flexibility and electrical isolation between the emission LEDs and photodetectors and the heat sink, a preferred embodiment of the invention may utilize a multiple layer substrate.

In an example useful for understanding the invention, a multiple layer substrate may include a first routing layer, a first dielectric layer, a second routing layer and a second dielectric layer. The first routing layer may be coupled to the electrical contacts of the emission LEDs and the one or more photodetectors, and may be formed on the first dielectric layer. In some cases, the first routing layer may have a thickness that ranges between about 10 µm to about 20 µm, and may be formed of a material (e.g., a copper or aluminum material, or an alloy thereof) having a thermal conductivity that ranges between 200 W/(mK) and about 400 W/(mK).

The first dielectric layer is coupled to a bottom surface of the first routing layer, and is sandwiched between the first routing layer and the second routing layer for electrically isolating the electrical contacts of the emission LEDs and the photodetectors from the heat sink. In an example useful for understanding the invention, the first dielectric layer may be a relatively thin layer having a thickness between about 10 µm and about 100 µm, and may be formed from a dielectric material having a relative permittivity that ranges between about 3 and 12. In one example, the first dielectric layer may be formed from an aluminum nitride material or an aluminum oxide material, but is not limited to such materials.

In addition to providing electrical isolation, the first dielectric layer provides a relatively high thermal impedance in the lateral direction by using a material with a relatively low thermal conductivity, which is less than about 150 W/(mK), and keeping the thickness of the layer small relative to the spacing between the emission LEDs and the photodetectors. In an example useful for understanding the invention, the first dielectric layer may have a thickness of about 30 µm, and the emission LEDs and photodetectors may be spaced at least 200-300 µm apart on an upper surface of the multiple layer substrate. Such an example would provide at least 10 times higher thermal conductivity in the vertical direction than in the lateral direction.

The second routing layer is coupled between the first dielectric layer and the second dielectric layer and is generally configured for routing signals between the first routing layer and external electrical contacts arranged outside of the primary optics structure. Like the first routing layer, the second routing layer may have a thickness that ranges between about 10 µm to about 20 µm, and may be formed of a material (e.g., a copper or aluminum material, or an alloy thereof) having a thermal conductivity that ranges between 200 W/(mK) and about 400 W/(mK). In some embodiments, vias may be formed within the first dielectric layer to route signals between the first routing layer and the second routing layer. These vias may be formed in accordance with any known process.

In an example useful for understanding the invention, the second dielectric layer may be coupled between the second routing layer and the heat sink. In other example useful for understanding the invention, a third routing layer may be coupled between the second dielectric layer and the heat sink. Unlike the first and second routing layers, which comprise metal lines printed on the first and second dielectric layers, the third routing layer may extend substantially continuously across an upper surface of the heat sink for improving the thermal contact between the plurality of thermally conductive lines and the heat sink and improving heat spreading there across.

Like the first dielectric layer, the second dielectric layer may be configured to provide a relatively high thermal impedance in the lateral direction by using a material with a relatively low thermal conductivity. For example, the second dielectric layer may be formed from a ceramic material (e.g., aluminum nitride) having a thermal conductivity less than about 150 W/(mK), or a ceramic material (e.g., aluminum oxide) having a thermal conductivity less than about 30 W/(mK). However, the first and second dielectric layers are not limited to ceramic materials, or even dielectric materials. In an example useful for understanding the invention, these layers may be formed using a laminate material, such as a printed circuit board (PCB) FR4 or a metal clad PCB material. However, since the thermal conductivity of laminate materials (e.g., less than about 1 W/(mK)) is significantly less than that of ceramic materials, using a laminate material in lieu of a ceramic material would reduce the thermal conductivity of the second dielectric layer.

Unlike the first dielectric layer, which is relatively thin, the second dielectric layer provides rigidity to the emitter module by utilizing a relatively thick layer (e.g., about 100 µm and about 1000 µm). In addition, the second dielectric layer includes a plurality of thermally conductive lines, which extend vertically through the second dielectric layer between the second routing layer and the heat sink, to improve thermal conductivity in the vertical direction.

As noted above, the plurality of thermally conductive lines may be formed from a material having a thermal conductivity that ranges between about 200W/(mK) and about 400 W/(mK), such as a copper or aluminum material, or an alloy thereof, and may be formed by drilling vertical holes through the second dielectric layer (using any mechanical or optical means), and filling or plating the holes (or vias) with an appropriate metal material using any appropriate method. In some embodiments, each thermally conductive line may comprise a plurality (e.g., about 10-20) of densely packed vias, with each via being a couple of hundred microns wide. In an example useful for understanding the invention, thermal conductivity may be further improved in the vertical direction by increasing the number of thermally conductive lines included under the emission LEDs. While this approach would provide better overall thermal conductivity from the LED array to the heat sink, it may provide worse thermal separation between the emission LEDs.

### BRIEF DESCRIPTION OF THE DRAWINGS

Other objects and advantages of the invention will become apparent upon reading the following detailed description and upon reference to the accompanying drawings.
Fig. 1 is a graph of the 1931 CIE chromaticity diagram illustrating the gamut of human color perception and the gamut achievable by an illumination device comprising a plurality of multiple color LEDs (e.g., red, green and blue);
Fig. 2 is a graph illustrating the non-linear relationship between relative luminous flux and junction temperature for white, blue and green LEDs;
Fig. 3 is a graph illustrating the substantially more non-linear relationship between relative luminous flux and junction temperature for red, red-orange and yellow (amber) LEDs;
Fig. 4 is a graph illustrating the non-linear relationship between relative luminous flux and drive current for red and red-orange LEDs;
Fig. 5 is a graph illustrating the substantially more non-linear relationship between relative luminous flux and drive current for white, blue and green LEDs;
Fig. 6 is a flow chart diagram of an improved method for calibrating an illumination device comprising a plurality of LEDs and one or more photodetectors, in accordance with one embodiment of the invention;
Fig. 7 is a chart illustrating an exemplary table of calibration values that may be obtained in accordance with the calibration method of Fig. 6 and stored within the illumination device;
Fig. 8A is a photograph of an exemplary illumination device;
Fig. 8B is a computer generated image showing a top view of an exemplary emitter module that may be included within the exemplary illumination device of Fig. 8A ;
Fig. 9A is a photograph of another exemplary illumination device;
Fig. 9B is a computer generated image showing a top view of an exemplary emitter module that may be included within the exemplary illumination device of Fig. 9A ;
Fig. 10A is a side view of an improved emitter module, according to an example useful for understanding the invention, the invention;
Fig. 10B is a side view of an improved emitter module, according to another example useful for understanding the invention;
Fig. 11 is an exemplary block diagram of circuit components that may be included within an illumination device, according to an example useful for understanding the invention, the invention;
Fig. 12 is an exemplary block diagram of an LED driver and receiver circuit that may be included within the illumination device of Fig. 11 according to an example useful for understanding the invention; and
Fig. 13 is an exemplary graph depicting how the spectrum of a phosphor converted LED may be divided into two portions, and showing how the phosphor efficiency decreases as the phosphor ages.

While the invention is susceptible to various modifications and alternative forms, specific embodiments thereof are shown by way of example in the drawings and will herein be described in detail. It should be understood, however, that the drawings and detailed description thereto are not intended to limit the invention to the particular form disclosed, but on the contrary, the intention is to cover all modifications, equivalents and alternatives falling within the scope of the present invention as defined by the appended claims.

### DETAILED DESCRIPTION OF THE PREFERRED EMBODIMENTS

An LED generally comprises a chip of semiconducting material doped with impurities to create a p-n junction. As in other diodes, current flows easily from the p-side, or anode, to the n-side, or cathode, but not in the reverse direction. Charge-carriers-electrons and holes-flow into the junction from electrodes with different voltages. When an electron meets a hole, it falls into a lower energy level, and releases energy in the form of a photon (i.e., light). The wavelength of the light emitted by the LED, and thus its color, depends on the band gap energy of the materials forming the p-n junction of the LED.

Red and yellow LEDs are commonly composed of materials (e.g., AlInGaP) having a relatively low band gap energy, and thus produce longer wavelengths of light. For example, most red and yellow LEDs have a peak wavelength in the range of approximately 610-650 nm and approximately 580-600 nm, respectively. On the other hand, green and blue LEDs are commonly composed of materials (e.g., GaN or InGaN) having a larger band gap energy, and thus, produce shorter wavelengths of light. For example, most green and blue LEDs have a peak wavelength in the range of approximately 515-550 nm and approximately 450-490 nm, respectively.

In some cases, a "white" LED may be formed by covering or coating, e.g., a blue LED having a peak emission wavelength of about 450-490nm with a phosphor (e.g., YAG), which down-converts the photons emitted by the blue LED to a lower energy level, or a longer peak emission wavelength, such as about 525nm to about 600nm. In some cases, such an LED may be configured to produce substantially white light having a correlated color temperature (CCT) of about 3000K. However, a skilled artisan would understand how different colors of LEDs and/or different phosphors may be used to produce a "white" LED with a potentially different CCT.

When two or more differently colored LEDs are combined within a single package, the spectral content of the individual LEDs are combined to produce blended light. In some cases, differently colored LEDs may be combined to produce white or near-white light within a wide gamut of color points or CCTs ranging from "warm white" (e.g., roughly 2600K-3000K), to "neutral white" (e.g., 3000K-4000K) to "cool white" (e.g., 4000K-8300K). Examples of white light illumination devices include, but are not limited to, those that combine red, green and blue (RGB) LEDs, red, green, blue and yellow (RGBY) LEDs, white and red (WR) LEDs, and RGBW LEDs.

The present invention is generally directed to illumination devices having a plurality of light emitting diodes (LEDs) and one or more photodetectors. For the sake of simplicity, the term "LED" will be used throughout this disclosure to refer to a single LED, or a chain of serially connected LEDs supplied with the same drive current. According to one embodiment, the present invention provides improved methods for calibrating and compensating individual LEDs within an LED illumination device, so as to accurately maintain a desired luminous flux and a desired chromaticity for the illumination device over changes in drive current, temperature and/or time.

Although not limited to such, the present invention is particularly well suited to illumination devices (i.e., multi-colored illumination devices) in which two or more different colors of LEDs are combined to produce blended white or near-white light, since the output characteristics of differently colored LEDs vary differently over drive current, temperature and time. The present invention is also particularly well suited to illumination devices (i.e., tunable illumination devices) that enable the target dimming level and/or the target chromaticity setting to be changed by adjusting the drive currents supplied to one or more of the LEDs, since changes in drive current inherently affect the lumen output, color and temperature of the illumination device.

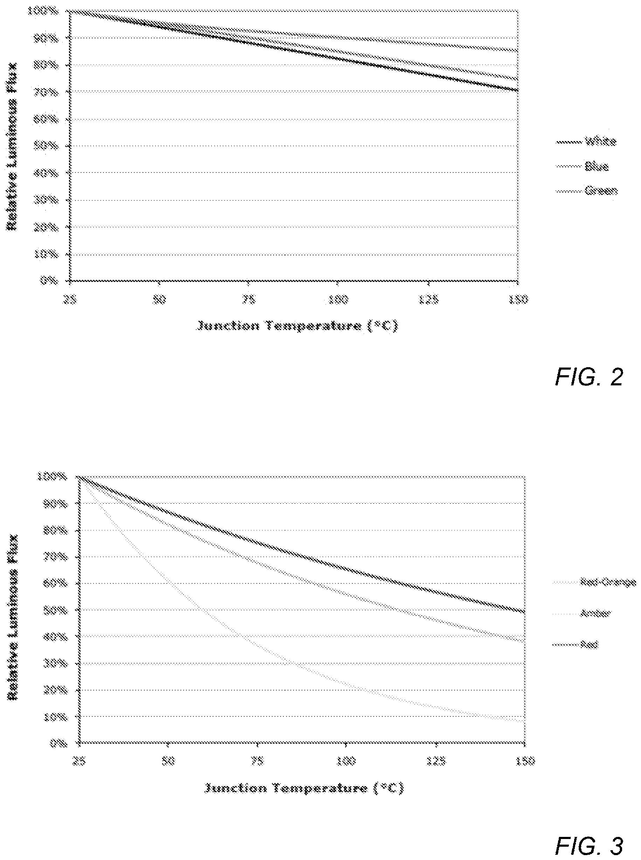

Figs. 2-3 illustrate how the relative luminous flux of an individual LED changes over junction temperature for different colors of LEDs. As shown in Figs. 2-3, the luminous flux output from all LEDs generally decreases with increasing temperature. For some colors (e.g., white, blue and green), the relationship between luminous flux and junction temperature is relatively linear (see Fig. 2), while for other colors (e.g., red, orange and especially yellow) the relationship is significantly non-linear (see, Fig. 3). The chromaticity of an LED also changes with temperature, due to shifts in the dominant wavelength (for both phosphor converted and non-phosphor converted LEDs) and changes in the phosphor efficiency (for phosphor converted LEDs). In general, the peak emission wavelength of green LEDs tends to decrease with increasing temperature, while the peak emission wavelength of red and blue LEDs tends to increase with increasing temperature. While the change in chromacity is relatively linear with temperature for most colors, red and yellow LEDs tend to exhibit a more significant non-linear change.

As LEDs age, the luminous flux output from both phosphor converted and non-phosphor converted LEDs, and the chromaticity of phosphor converted LEDs, also changes over time. Early on in life, the luminous flux can either increase (get brighter) or decrease (get dimmer), while late in life, the luminous flux generally decreases. As expected, the lumen output decreases faster over time when the LEDs are subjected to higher drive currents and higher temperatures. As a phosphor converted LED ages, the phosphor becomes less efficient and the amount of blue light that passes through the phosphor increases. This decrease in phosphor efficiency causes the overall color produced by the phosphor converted LED to appear "cooler" over time. Although the dominant wavelength and chromaticity of a non-phosphor converted LED does not change over time, the luminous flux decreases as the LED ages, which in effect causes the chromaticity of a multi-colored LED illumination device to change over time.

When differently colored LEDs are combined within a multi-colored illumination device, the color point of the resulting device often changes significantly with variations in temperature and over time. For example, when red, green and blue LEDs are combined within a white light illumination device, the color point of the device may appear increasingly "cooler" as the temperature rises. This is because the luminous flux produced by the red LEDs decreases significantly as temperatures increase, while the luminous flux produced by the green and blue LEDs remains relatively stable (see, Figs. 2-3).

To account for temperature and aging effects, some prior art illumination devices attempt to maintain a consistent lumen output and/or a consistent chromaticity over temperature and time by measuring characteristics of the emission LEDs and increasing the drive current supplied to one or more of the emission LEDs. For example, some prior art illumination devices measure the temperature of the illumination device (either directly through an ambient temperature sensor or heat sink measurement, or indirectly through a forward voltage measurement), and adjust the drive currents supplied to one or more of the emission LEDs to account for temperature related changes in lumen output. Other prior art illumination devices measure the lumen output from individual emission LEDs, and if the measured value differs from a target value, the drive currents supplied to the emission LED are increased to account for changes in luminous flux that occur over time.

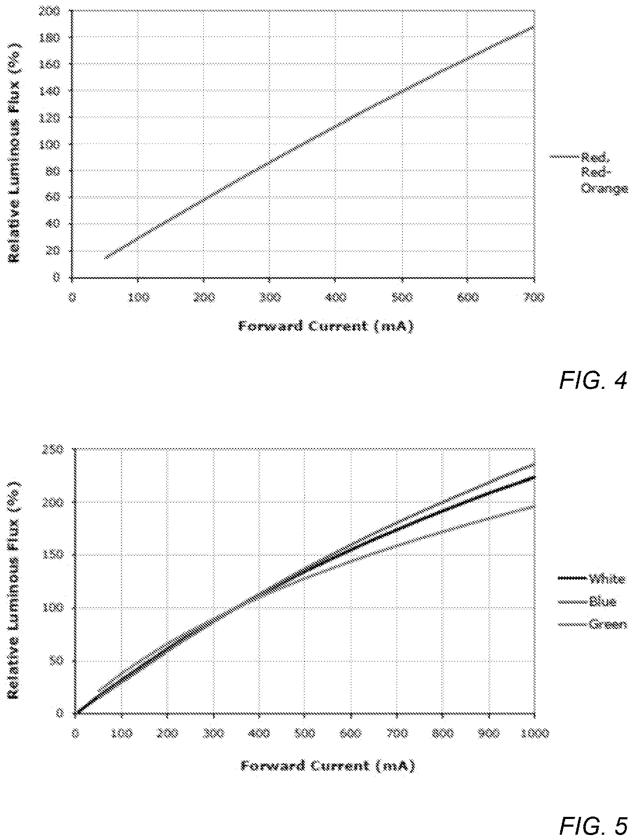

However, changing the drive currents supplied to the emission LEDs inherently affects the luminous flux and the chromaticity produced by the LED illumination device. Figs. 4 and 5 illustrate the relationship between luminous flux and drive current for different colors of LEDs (e.g., red, red-orange, white, blue and green LEDs). In general, the luminous flux increases with larger drive currents, and decreases with smaller drive currents. However, the change in luminous flux with drive current is non-linear for all colors of LEDs, and this non-linear relationship is substantially more pronounced for certain colors of LEDs (e.g., blue and green LEDs) than others. The chromaticity of the illumination also changes when drive currents are increased to combat temperature and/or aging effects, since larger drive currents inherently result in higher LED junction temperatures (see, Figs. 2-3). While the change in chromaticity with drive current/temperature is relatively linear for all colors of LEDs, the rate of change is different for different LED colors and even from part to part.

Although some prior art illumination devices may adjust the drive currents supplied to the emission LEDs, these devices fail to provide accurate temperature and age compensation by failing to account for the non-linear relationship that exists between luminous flux and junction temperature for certain colors of LEDs (Figs. 2-3), the non-linear relationship that exists between luminous flux and drive current for all colors of LEDs (Figs. 4-5), and the fact that these relationships differ for different colors of LEDs. These devices also fail to account for the fact that the rate of change in chromaticity with drive current/temperature is different for different colors of LEDs. Without accounting for these behaviors, prior art illumination devices cannot provide accurate temperature and age compensation for all LEDs included within a multi-colored LED illumination device.

A need remains for improved illumination devices and methods for calibrating and compensating individual LEDs included within an illumination device, so as to maintain a desired luminous flux and a desired chromaticity over variations in drive current and temperature and over time, as the LEDs age. This need is particularly relevant to multi-colored LED illumination devices, since different LED colors respond differently over temperature and time, and to illumination devices that provide dimming and/or color tuning capabilities, since changes in drive current inherently affect the lumen output, color and temperature of the illumination device.

In order to meet these needs, improved illumination devices and methods are provided herein to individually calibrate and compensate each LED used in the LED illumination device. The improved calibration and compensation methods described herein overcome the disadvantages of conventional methods, which fail to provide accurate temperature and age compensation for all LEDs included within an LED illumination device.

### Exemplary Embodiments of Improved Methods for Calibrating an Illumination Device

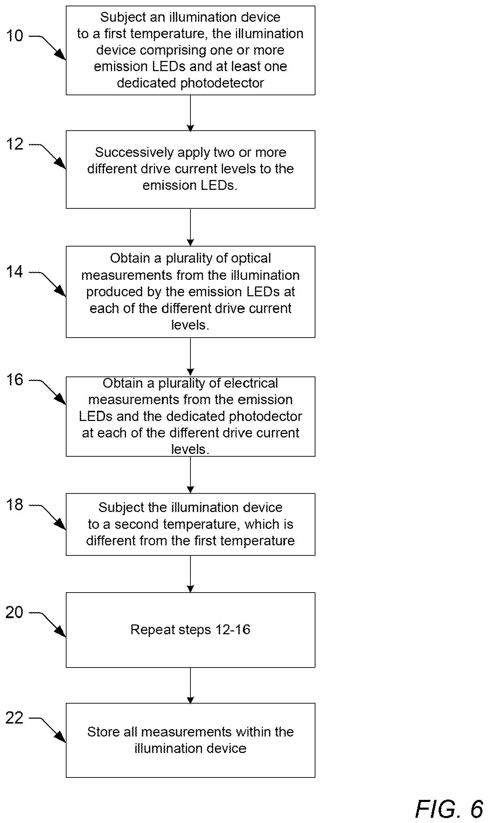

Fig. 6 illustrates one embodiment of an improved method for calibrating an illumination device comprising a plurality of LEDs and at least one dedicated photodetector. In some embodiments, the calibration method shown in Fig. 6 may be used to calibrate an illumination device having LEDs all of the same color. However, the calibration method described herein is particularly well-suited for calibrating an illumination device comprising two or more differently colored LEDs (i.e., a multi-colored LED illumination device), since output characteristics of differently colored LEDs vary differently over drive current, temperature and time. The calibration method described herein is also particularly well-suited for calibrating an illumination device that provides dimming and/or color tuning capabilities (i.e., a tunable LED illumination device), since changes in drive current inherently affect the lumen output, color and temperature of the illumination device.

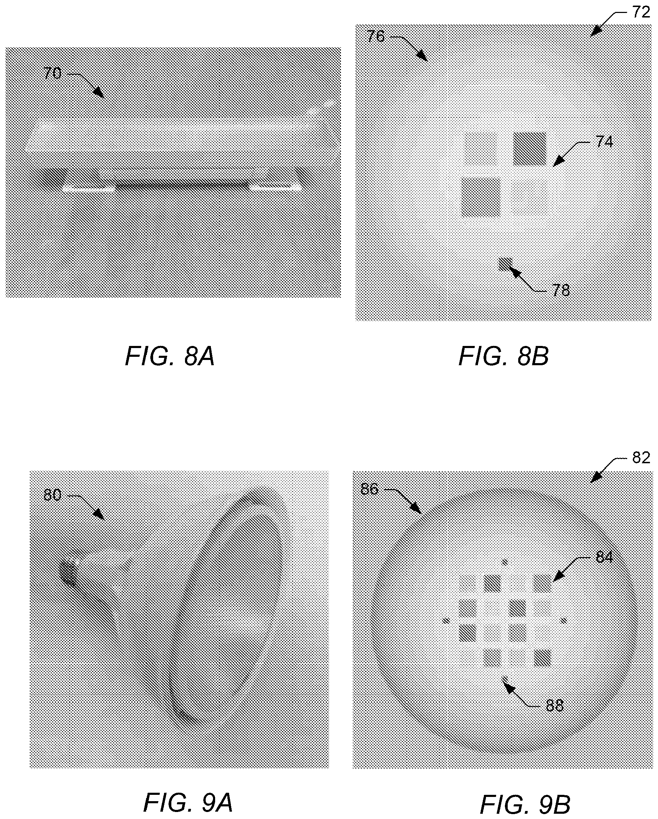

Exemplary embodiments of an improved illumination device will be described below with reference to Figs. 8-12 , which show different types of LED illumination devices, each having one or more emitter modules. As described below, each emitter module may generally include a plurality of emission LEDs arranged in an array, and at least one dedicated photodetector spaced about a periphery of the array. In one exemplary embodiment, the array of emission LEDs may include red, green, blue and white (or yellow) LEDs, and the at least one dedicated photodetector may include one or more red, orange, yellow and/or green LEDs. However, the present invention is not limited to any particular color, number, combination or arrangement of emission LEDs or photodetectors. A skilled artisan would understand how the method steps described herein may be applied to other LED illumination devices having substantially different emitter modules.

As shown in Fig. 6, the improved calibration method begins by subjecting the illumination device to a first ambient temperature (in step 10). Once subjected to this temperature, two or more drive current levels are applied to the emission LEDs (in step 12) and a plurality of measurements are obtained from both the emission LEDs and the dedicated photodetector LED(s) at each of the different drive current levels (in steps 14 and 16). Specifically, two or more drive current levels are successively applied to each emission LED, one LED at a time, for the purpose of obtaining measurements from the illumination device. These measurements generally include optical measurements and electrical measurements.

A plurality of optical measurements are obtained from the illumination produced by each emission LED at each of the different drive current levels (in step 14). According to one embodiment, the optical measurements may include a plurality of luminous flux, x chromaticity and y chromaticity measurements, which are obtained for each emission LED at two or more different drive current levels. However, the optical measurements described herein are not limited to luminous flux, x chromaticity and y chromaticity, and may include additional or alternative optical measurements in other embodiments of the invention.

In general, the chromaticity calibration values described herein may correspond to the CIE 1931 XYZ color space, the CIE 1931 RGB color space, the CIE 1976 LUV color space, and various other RGB color spaces (e.g., sRGB, Adobe RGB, etc.). Although the calibration and compensation methods described herein acquire and utilize only x and y chromaticity calibration values, one skilled in the art would understand how chromaticity values from other color spaces could be alternatively acquired and used in the methods described herein. As such, the calibration and compensation methods described herein and recited in the claims are considered to encompass chromaticity calibration values from any color space that can be used to describe the gamut of an LED illumination device comprising substantially any combination of emission LEDs as described herein.

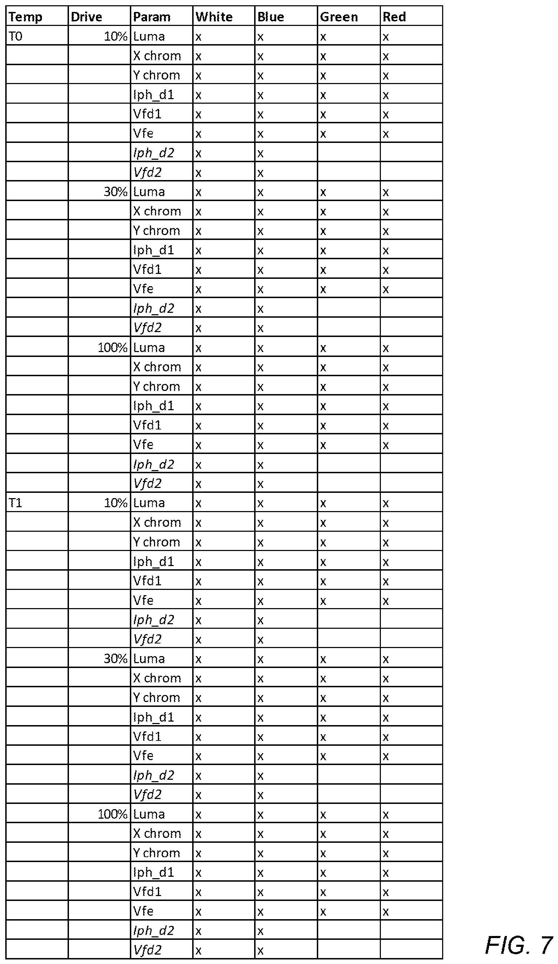

In one preferred embodiment, three luminous flux (Luma) measurements, three x chromaticity (x chrom) measurements, and three y chromaticity (y chrom) measurements are measured from each emission LED at roughly a maximum drive current level (typically about 500 mA, depending on LED part number and manufacturer), roughly 30% of the maximum drive current, and roughly 10% of the maximum drive current, as shown in Fig. 7 and discussed below. In some embodiments, the luminous flux and x, y chromaticity measurements may be obtained from the emission LEDs using an external calibration tool, such as a spectrophotometer. In some embodiments, the measurement values obtained from the external calibration tool may be transmitted wirelessly to the illumination device, as described in more detail below with respect to Fig. 19.

In addition, a plurality of electrical measurements are obtained from each of the emission LEDs and each of the dedicated photodetector(s) at each of the different drive current levels (in step 16). These electrical measurements include, but are not limited to, photocurrents induced on the dedicated photodetector(s) and forward voltages measured across the dedicated photodetector(s) and/or the emission LEDs. Unlike the optical measurements described above, the electrical measurements may be obtained from the dedicated photodetector(s) and the emission LEDs using the LED driver and receiver circuit included within the illumination device. An exemplary embodiment of such a circuit is shown in Figs. 19-20 and described in more detail below.

At each of the different drive currents levels, the LED driver and receiver circuit measures the photocurrents that are induced on the dedicated photodetector by the illumination individually produced by each emission LED. In one preferred embodiment, three photocurrent (Iph_d1) measurements may be obtained from the dedicated photodetector for each emission LED when the emission LEDs are successively driven to produce illumination at three different drive current levels (e.g., 100%, 30% and 10% of a max drive level). In some embodiments, the LED driver and receiver circuit may obtain the photocurrent (Iph_d1) measurements at substantially the same time the external calibration tool is measuring the luminous flux and x and y chromaticity of the illumination produced by the emission LEDs at each of the different drive current levels.

In general, the drive currents applied to the emission LEDs to measure luminous flux, chromaticity and induced photocurrent may be operative drive current levels (e.g., about 20 mA to about 500 mA). In some cases, increasingly greater drive current levels may be successively applied to each of the emission LEDs to obtain the measurements described herein. In other cases, the measurements may be obtained upon successively applying decreasing levels of drive current to the emission LEDs. The order in which the drive current levels are applied is largely unimportant, only that the drive currents be different from one another.

Although examples are provided herein, the present invention is not limited to any particular value or any particular number of drive current levels, and may apply substantially any value and any number of drive current levels to an emission LED within the operating current level range of that LED. However, it is generally desired to obtain the luminous flux and chromaticity measurements from the emission LEDs and the photocurrent measurements from the photodetector at a sufficient number of different drive current levels, so that the non-linear relationship between these measurements and drive current can be accurately characterized across the operating current level range of the LED.

While increasing the number of measurements does improve the accuracy with which the non-linear relationships are characterized, it also increases the calibration time and costs. While the increase in calibration time and cost may not be warranted in all cases, it may be beneficial in some. For example, additional luminous flux measurements may be beneficial when attempting to characterize the luminous flux vs. drive current relationship for certain colors of LEDs (e.g., blue and green LEDs), which tend to exhibit a significantly more non-linear relationship than other colors of LEDs (see, Figs. 4-5). Thus, a balance should be struck between accuracy and calibration time/costs when selecting a desired number of drive current levels with which to obtain measurements for a particular color of LED.

Since increasing drive currents affect the junction temperature of the emission LEDs, a forward voltage may be measured across each emission LED and each photodetector immediately after each operative drive current level is supplied to the emission LEDs (in step 16). For each operative drive current level, the forward voltages can be measured across each emission LED and each photodetector before or after the photocurrent measurements for that operative drive current level are obtained. Unlike the optical measurements, however, relatively small drive currents are applied to the emission LEDs and the dedicated photodetector(s) to measure the forward voltages developed there across.

In one preferred embodiment, three forward voltage (Vfe) measurements may be obtained from each emission LED and three forward voltage (Vfd1) measurements may be obtained from each dedicated photodetector (in step 16) immediately after each of the different drive current levels (e.g., 100%, 30% and 10% of a max drive level) is applied to the emission LEDs to measure the luminous flux, x chromaticity and y chromaticity. The forward voltage (Vfe and Vfd1) measurements can be obtained before or after the induced photocurrents (Iph_d1) are measured at each of the different drive current levels. By measuring the forward voltage (Vfe) across each emission LED and the forward voltage (Vfd1) across each dedicated photodetector immediately after each operative drive current level is applied to the emission LEDs, the Vfe and Vfd1 measurements may be used to provide a good indication of how the junction temperature of the emission LEDs and the dedicated photodetector change with changes in drive current.

When taking forward voltage measurements, a relatively small drive current is supplied to each of the emission LEDs and each of the dedicated photodetector LEDs, one LED at a time, so that a forward voltage (Vfe or Vfd1) developed across the anode and cathode of the individual LEDs can be measured (in step 16). When taking these measurements, all other emission LEDs in the illumination device are preferably turned "off to avoid inaccurate forward voltage measurements (since light from other emission LEDs would induce additional photocurrents in the LED being measured).

As used herein, a "relatively small drive current" may be broadly defined as a non-operative drive current, or a drive current level which is insufficient to produce significant illumination from the LED. Most LED device manufacturers, which use forward voltage measurements to compensate for temperature variations, supply a relatively large drive current to the LEDs (e.g., an operative drive current level sufficient to produce illumination from the LEDs) when taking forward voltage measurements. Unfortunately, forward voltages measured at operative drive current levels tend to vary significantly over the lifetime of an LED. As an LED ages, the parasitic resistance within the junction increases, which in turn, causes the forward voltage measured at operating current levels to increase over time, regardless of temperature. For this reason, a relatively small (i.e., non-operative) drive current is used herein when obtaining forward voltage measurements to limit the resistive portion of the forward voltage drop.

For some common types of emission LEDs with one square millimeter of junction area, the optimum drive current used herein to obtain forward voltage measurements from the emission LEDs may be roughly 0.1-10 mA, and more preferably may be about 0.3-3 mA. In one embodiment, the optimum drive current level may be about 1 mA for obtaining forward voltage measurements from the emission LEDs. However, smaller/larger LEDs may use proportionally less/more current to keep the current density roughly the same. In the embodiments that use a significantly smaller LED as the dedicated photodetector, the optimum drive current level for obtaining forward voltage measurements from a single photodetector may range between about 100 µA to about 300 µA. In one embodiment, the optimum drive current level used for obtaining forward voltage measurements from a plurality of dedicated photodetectors connected in parallel may be about 1mA. The relatively small, non-operative drive currents used to obtain forward voltage measurements from the emission LEDs (e.g., about 0.3 mA to about 3 mA) and the relatively small, non-operative drive currents used to obtain forward voltage measurements from a dedicated photodetector (e.g., about 100 µA to about 300 µA) are substantially smaller than the operative drive current levels (e.g., about 20 mA to about 500 mA) used in steps 14 and 16 to measure luminous flux, chromaticity and induced photocurrent.

After the measurements described in steps 14-16 are obtained at the first temperature, the illumination device is subjected to a second ambient temperature, which is substantially different from the first ambient temperature (in step 18). Once subjected to this second temperature, steps 12-16 are repeated (in step 20) to obtain an additional plurality of optical measurements from each of the emission LEDs (in step 14), and an additional plurality of electrical measurements from the emission LEDs and the dedicated photodetector (in step 16). The additional measurements may be obtained at the second ambient temperature in the same manner described above for the first ambient temperature.

In one embodiment, the second ambient temperature may be substantially less than the first ambient temperature. For example, the second ambient temperature may be approximately equal to room temperature (e.g., roughly 25°C), and the first ambient temperature may be substantially greater than room temperature. In one example, the first ambient temperature may be closer to an elevated temperature (e.g., roughly 70°C) or a maximum temperature (e.g., roughly 85°C) at which the device is expected to operate. In an alternative embodiment, the second ambient temperature may be substantially greater than the first ambient temperature.

It is worth noting that the exact values, number and order in which the temperatures are applied to calibrate the individual LEDs is somewhat unimportant. However, it is generally desired to obtain the luminous flux, x and y chromaticity, and photocurrent calibration values at a number of different temperatures, so that the non-linear relationships between these measurements and drive current can be accurately characterized across the operating temperature range of each LED. In one preferred embodiment, the illumination device may be subjected to two substantially different ambient temperatures, which are selected from across the operating temperature range of the illumination device. While it is possible to obtain the measurements described herein at three (or more) temperatures, doing so may add significant expense, complexity and/or time to the calibration process. For this reason, it is generally preferred that the emission LEDs and the dedicated photodetector(s) be calibrated at only two different temperatures (e.g., about 25°C and about 70°C).

In some embodiments, the illumination device may be subjected to the first and second ambient temperatures by artificially generating the temperatures during the calibration process. However, it is generally preferred that the first and second ambient temperatures are ones which occur naturally during production of the illumination device, as this simplifies the calibration process and significantly decreases the costs associated therewith. In one embodiment, the measurements obtained at the elevated temperature may be taken after burn-in of the LEDs when the illumination device is relatively hot (e.g., roughly 50°C to 85°C), and sometime thereafter (e.g., at the end of the manufacturing line), a room temperature calibration may be performed to obtain measurements when the illumination device is relatively cool (e.g., roughly 20°C to 30°C).

Once the calibration measurements are obtained, the calibration values are stored within the illumination device (in step 22), so that the stored values can be later used to compensate the illumination device for changes in luminous flux and/or chromaticity that may occur over variations in drive current, temperature and time. In one embodiment, the calibration values may be stored within a table of calibration values as shown, for example, in Fig. 7. The table of calibration values may be stored within a storage medium of the illumination device, as discussed below with reference to Fig. 19.

Fig. 7 illustrates one embodiment of a calibration table that may be generated in accordance with the calibration method shown in Fig. 6. In the illustrated embodiment, the calibration table includes six luminous flux measurements (Luma), six x chromaticity measurements (x chrom), and six y chromaticity measurements (y chrom), which were obtained from each emission LED (e.g., white, blue, green and red emission LEDs) at the three different drive currents (e.g., 10%, 30% and 100% of a max drive current) and the two different temperatures (T0, T1) in steps 10, 12, 14, 18, 20 and 22 of the calibration method. The calibration table shown in Fig. 7 also includes six photocurrent measurements (Iph_d1) that were induced on the photodetector by the illumination produced by each of the emission LEDs at the three different drive currents levels and the two different temperatures in steps 10, 12, 16, 20 and 22 of the calibration method.

For each emission LED (e.g., each white, blue, green and red emission LED) and each ambient temperature (T0, T1), the calibration table shown in Fig. 7 also includes the forward voltage (Vfe) that was measured across the emission LED and the forward voltage (Vfd1) that was measured across the dedicated photodetector immediately after each of the three different drive currents levels is supplied to the emission LEDs. In this example embodiment, steps 10, 12, 16, 18, 20 and 22 of the calibration method result in six Vfe measurements and six Vfd1 measurements being stored for each emission LED, as shown in Fig. 7.

The calibration table shown in Fig. 7 represents only one example of the calibration values that may be stored within an LED illumination device, in accordance with the calibration method described herein. In some embodiments, the calibration method shown in Fig. 6 may be used to store substantially different calibration values, or substantially different numbers of calibration values, within the calibration table of the LED illumination device.

As noted above, the present invention is not limited to the exemplary number of drive current levels and values of drive current shown in Figs. 6 and 7. It is certainly possible to obtain a greater/lesser number of optical and electrical measurements from the emission LEDs and the at least one dedicated photodetector by applying a greater/lesser number of drive current levels to the emission LEDs. It is also possible to use substantially different values of drive current, other than the 10%, 30% and 100% of the max drive current illustrated in Fig. 7.

It is also possible to obtain and store a different number of forward voltage (Vfe) measurements from the emission LEDs, or a different number of forward voltage (Vfd1) measurements from the at least one dedicated photodetector. For example, the calibration table shown in the embodiment of Fig. 7 stores six forward voltage (Vfe) measurements from each emission LED and six*n forward voltage (Vfd1) measurements from each dedicated photodetector, where 'n' is the number of emission LEDs included within the illumination device. As noted above, the six Vfe measurements and six*n Vfd measurements are preferably obtained at two different ambient temperatures (T0, T1) immediately after each operative drive current level (e.g., 10%, 30% and 100% of a max drive current) is applied to each emission LED. Such an embodiment is generally preferred, as it provides a good indication of how the emitter and detector junction temperatures change with changes in ambient temperature and changes in drive current.

As shown in Figs. 6-7 and described above, the calibration method may obtain only one Vfe and only one Vfd1 measurement for each emission LED at a given temperature (e.g., T0) and a given drive current (e.g., 10% of the max drive current). In one alternative embodiment, the calibration method of Fig. 6 may obtain a plurality of Vfe and a plurality of Vfdl measurements for each emission LED at a given temperature (e.g., T0) and a given drive current (e.g., 10% of the max drive current). The plurality of Vfe and Vfdl measurements may be obtained over a short period of time (e.g., 100 msec), and the plurality of Vfe measurements and the plurality of Vfdl measurements obtained during each time period may be averaged and filtered before they are stored within the calibration table of Fig. 7.

In another alternative embodiment, the calibration method of Fig. 6 may obtain only two forward voltage (Vfe) measurements from each emission LED, one for each of the two different temperatures (T0, T1), as described in commonly assigned U.S. Patent Application Serial Nos. 13/970,944, 13/970,964 and 13/970,990. Likewise, only two*n forward voltage (Vfd1) measurements may be obtained from the dedicated photodetector, where 'n' is the number of emission LEDs included within the illumination device. In this embodiment, however, the forward voltage (Vfe and Vfd1) measurements stored in the calibration table would only provide an indication of how the emitter and detector junction temperatures change with changes in ambient temperature, not with drive current induced temperature changes.

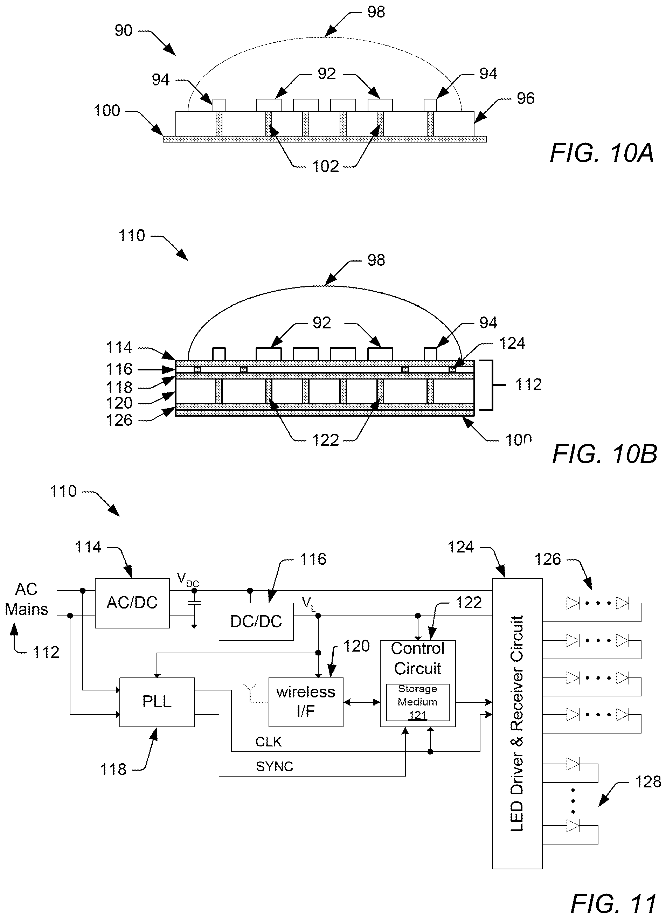

In another alternative embodiment of the invention, the calibration method shown in Fig. 6 may omit the emitter forward voltage (Vfe) measurements altogether, and rely solely on the photodetector forward voltage (Vfd1) measurements to provide an indication of temperature. However, the Vfe measurements may only be omitted if the temperature difference between the emission LEDs and the dedicated photodetector(s) remains relatively the same over the operating temperature range. To maintain a consistent temperature difference between the emission LEDs and the photodetector(s), an improved emitter module is provided herein and described below with reference to Fig. 10A.

In yet another alternative embodiment of the invention, the calibration method shown in Fig. 6 may be used to obtain additional measurements, which may be later used to compensate for phosphor aging, and thereby, control the chromaticity of a phosphor converted white LED over time.

As noted above, some embodiments of the invention may include a phosphor converted white emission LED within the emitter module. These LEDs may be formed by coating or covering, e.g., a blue LED having a peak emission wavelength of about 400-500 with a phosphor material (e.g., YAG) to produce substantially white light with a CCT of about 3000K. Other combinations of LEDs and phosphors may be used to form a phosphor converted LED, which is capable of producing white or near-white light with a CCT in the range of about 2700K to about 10,000k.

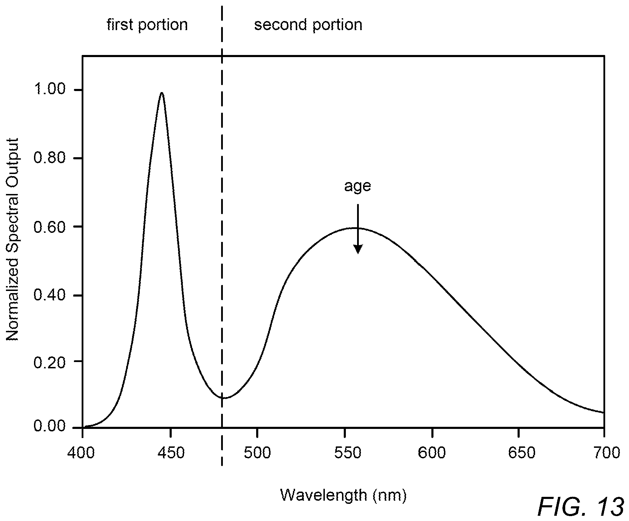

In phosphor converted LEDs, the spectral content of the LED combines with the spectral content of the phosphor to produce white or near-white light. As shown in Fig. 13 , the combined spectrum may include a first portion having a first peak emission wavelength (e.g., about 400-500), and a second portion having a second peak emission wavelength (e.g., about 500-650), which is substantially different from the first peak emission wavelength. In this example, the first portion of the spectrum is generated by the light emitted by the blue LED, and the second portion is generated by the light that passes through the phosphor (e.g., YAG).

As the phosphor converted LED ages, the efficiency of the phosphor decreases, which causes the chromaticity of the phosphor converted LED to appear "cooler" over time. In order to account for age-related chromaticity shifts in a phosphor converted LED, it may be desirable in some embodiments of the calibration method shown in Fig. 6 to measure the photocurrents induced by the LED portion and the photocurrents induced by the phosphor portion of the phosphor converted LED separately. Thus, some embodiments of the invention may use two different colors of photodetectors to measure photocurrents, which are separately induced by different portions of the phosphor converted LED spectrum. In particular, an emitter module of the illumination device may include a first photodetector whose detection range is configured for detecting only the first portion of the spectrum emitted by the phosphor converted LED, and a second photodetector whose detection range is configured for detecting only the second portion of the spectrum emitted by the phosphor converted LED.

In general, the detection range of the first and second photodetectors may be selected based on the spectrum of the phosphor converted LED being measured. In the exemplary embodiment described above, in which a phosphor converted white emission LED is included within the emitter module and implemented as described above, the detection range of the first photodetector may range between about 400nm and about 500nm for measuring the photocurrents induced by light emitted by the blue LED portion, and the detection range of the second photodetector may range between about 500nm and about 650nm for measuring the photocurrents induced by light that passes through the phosphor portion of the phosphor converted white LED. The first and second photodetectors may include dedicated photodetectors and/or emission LEDs, which are sometimes configured for detecting incident light.

As noted above, the emitter module of the illumination device preferably includes at least one dedicated photodetector. In one embodiment, the emitter module may include two different colors of dedicated photodetectors, such as one or more dedicated green photodetectors and one or more dedicated red photodetectors (see, e.g., Fig. 9B). In another embodiment, the emitter module may include only one dedicated photodetector, such as a single red, orange or yellow photodetector (see, e.g., Fig. 8B). In such an embodiment, one of the emission LEDs (e.g., the green emission LED) may be configured, at times, as a photodetector for measuring a portion of the phosphor converted LED spectrum.

In the calibration method described above and shown in Fig. 6, the at least one dedicated photodetector may be used in step 16 to measure the photocurrents (Iph_d1), which are induced in the dedicated photodetector by the illumination produced by each of the emission LEDs when the emission LEDs are successively driven to produce illumination at the plurality of different drive current levels (e.g., 100%, 30% and 10% of a max drive level) and the plurality of different temperatures (e.g., TO and T1). Sometime before or after each of the photocurrent measurements (Iph_d1) is obtained from the dedicated photodetector, a forward voltage (Vfd1) is measured across the dedicated photodetector to provide an indication of the detector junction temperature at each of the calibrated drive current levels.

In some embodiments of the calibration method shown in Fig. 6, the dedicated photodetector used to obtain the photocurrent (Iph_d1) and forward voltage (Vfd1) measurements may be, e.g., a red LED. When calibrating a phosphor converted white LED, the dedicated red photodetector may be used to measure the photocurrent (Iph_d1) induced by the light that passes through the phosphor (i.e., the "second portion" of the spectrum shown in Fig. 13). In some embodiments, another dedicated photodetector (or one of the emission LEDs) may be used to measure the photocurrent (Iph_d2), which is induced by the light emitted by the LED portion (i.e., the "first portion" of the spectrum shown in Fig. 13) of the phosphor converted white LED. This photodetector may be, for example, a dedicated green photodetector or one of the green emission LEDs.

As shown in Fig. 7, the additional photodetector may be used in step 16 of the calibration method shown in Fig. 6 to measure the photocurrents (Iph_d2), which are induced in the additional photodetector by the illumination produced by the LED portion of the phosphor converted white LED when that LED is successively driven to produce illumination at a plurality of different drive current levels (e.g., 100%, 30% and 10% of a max drive level) and a plurality of different temperatures (e.g., TO and T1). In addition to measuring the photocurrents induced by the LED portion of the phosphor converted white LED, the photocurrents (Iph_d2) induced by the illumination produced by the blue emission LED may also be obtained from the additional photodetector in step 16. Before or after each of the photocurrent measurements (Iph_d2) is obtained from the additional photodetector, a forward voltage (Vfd2) is measured across the additional photodetector to provide an indication of the detector junction temperature at each of the calibrated drive current levels.

In addition to storing separate photocurrent measurements (Iph_d2 and Iph_d1) for the phosphor converted white LED, the calibration table may also store separate luminous flux (Luma), x chromaticity (x chrom) and y chromaticity (y chrom) measurements for the LED portion and the phosphor portion of the phosphor converted white LED spectrum at each of the calibrated drive currents and temperatures. While this is not explicitly shown in Fig. 7, measuring the luminous flux (Luma), x chromaticity (x chrom) and y chromaticity (y chrom) attributed to each portion of the phosphor converted white LED spectrum, and storing these values within the calibration table, the stored calibration values may be later used during one or more of the compensation methods described herein to control the luminous flux and chromaticity of the LED portion and the phosphor portion of the phosphor converted white LED, separately, as if the LED were two different LEDs.

Exemplary methods for calibrating an illumination device comprising a plurality of emission LEDs and one or more photodetectors has now been described with reference to Figs. 6-7. Although the method steps shown in Fig. 6 are described as occurring in a particular order, one or more of the steps of the illustrated method may be performed in a substantially different order. In one alternative embodiment, for example, the plurality of electrical measurements (e.g., Iph, Vfd and Vfe) may be obtained from the one or more photodetector(s) and emission LEDs in step 16 before the plurality of optical measurements (e.g., Luma, x chrom, y chrom) are obtained from the emission LEDs in step 14. In another alternative embodiment, the external calibration tool may obtain the optical measurements (in step 14) at substantially the same time as the LED driver and receiver circuit is obtaining the electrical measurements (in step 16). While the calibration method shown in Fig. 6 stores the calibration values within the illumination device at the end of the calibration method (e.g., in step 22), a skilled artisan would recognize that these values may be stored at substantially any time during the calibration process without departing from the scope of the invention. The calibration method described herein is considered to encompass all such variations and alternative embodiments.

The calibration method provided herein improves upon conventional calibration methods in a number of ways. First, the method described herein calibrates each emission LED (or chain of LEDs) individually, while turning off all other emission LEDs not currently under test. This not only improves the accuracy of the stored calibration values, but also enables the stored calibration values to account for process variations between individual LEDs, as well as differences in output characteristics that inherently occur between different colors of LEDs.

Accuracy is further improved herein by supplying a relatively small (i.e., non-operative) drive current to the emission LEDs and the photodetector(s) when obtaining forward voltage measurements, as opposed to the operative drive current levels typically used in conventional calibration methods. By using non-operative drive currents to obtain the forward voltage measurements, the present invention avoids inaccurate compensation by ensuring that the forward voltage measurements for a given temperature and fixed drive current do not change significantly over time (due to parasitic resistances in the junction when operative drive currents are used to obtain forward voltage measurements).

As another advantage, the calibration method described herein obtains a plurality of optical measurements from each emission LED and a plurality of electrical measurements from each photodetector at a plurality of different drive current levels and a plurality of different temperatures. This further improves calibration accuracy by enabling the non-linear relationship between luminous flux and drive current and the non-linear relationship between photocurrent and drive current to be precisely characterized for each individual LED. Furthermore, obtaining the calibration values at a number of different ambient temperatures improves compensation accuracy by enabling the compensation methods (described below) to interpolate between the stored calibration values, so that accurate compensation values may be determined for current operating temperatures.

As yet another advantage, the calibration method described herein may use different colors of photodetectors to measure photocurrents, which are induced by different portions (e.g., an LED portion and a phosphor portion) of a phosphor converted LED spectrum. The different colors of photodetectors may also be used to measure the photocurrent, which is induced by a reference emission LED, whose peak emission wavelength falls within the LED portion of the spectrum emitted by the phosphor converted LED. By storing these calibration values within the illumination device, the calibration values may be later used to detect and account for chromaticity shifts that may occur in a phosphor converted LED over time.

As described in more detail below, the calibration values stored within the calibration table can be used in one or more compensation methods described herein to adjust the individual drive currents supplied to the emission LEDs, so as to obtain a desired luminous flux and a desired chromaticity over changes in drive current, changes in temperature and over time, as the LEDs age. For example, the luminous flux (Luma) measurements may be used in some embodiments to maintain a consistent lumen output and chromaticity over changes in temperature. In other embodiments, the luminous flux (Luma) measurements may be used along with the chromaticity (e.g., x chrom, y chrom) measurements to obtain a new target lumen output or a new target chromaticity when the dimming level or color point setting for the illumination device is changed. Regardless of the particular luminous flux or chromaticity setting used, the photocurrent (Iph) measurements may be used to adjust the individual drive currents supplied to the emission LEDs to account for LED aging effects. While the most accurate results may be obtained by utilizing all such measurements when compensating an LED illumination device, one skilled in the art would understand how one or more of the calibration values described herein may be used to improve upon the compensation methods performed by prior art illumination devices.

### Examples of Improved Illumination Devices

The improved methods described herein for calibrating and controlling an illumination device may be used within substantially any LED illumination device having a plurality of emission LEDs and one or more photodetectors. As described in more detail below, the improved methods described herein may be implemented within an LED illumination device in the form of hardware, software or a combination of both.

Illumination devices, which benefit from the improved methods described herein, may have substantially any form factor including, but not limited to, parabolic lamps (e.g., PAR 20, 30 or 38), linear lamps, flood lights and mini-reflectors. In some cases, the illumination devices may be installed in a ceiling or wall of a building, and may be connected to an AC mains or some other AC power source. However, a skilled artisan would understand how the improved methods described herein may be used within other types of illumination devices powered by other power sources (e.g., batteries or solar energy).

In an example useful for understanding the invention an improved illumination device will now be described with reference to Figs. 8-12 , which show different types of LED illumination devices, each having one or more emitter modules. Although examples are provided herein, the present invention is not limited to any particular type of LED illumination device or emitter module design. A skilled artisan would understand how the method steps described herein may be applied to other types of LED illumination devices having substantially different emitter module designs.

Fig. 8A is a photograph of a linear lamp 70 comprising a plurality of emitter modules (not shown in Fig. 8A), which are spaced apart from one another and arranged generally in a line. Each emitter module included within linear lamp 70 includes a plurality of emission LEDs and at least one dedicated photodetector, all of which are mounted onto a common substrate and encapsulated within a primary optics structure. The primary optics structure may be formed from a variety of different materials and may have substantially any shape and/or dimensions necessary to shape the light emitted by the emission LEDs in a desirable manner. Although the primary optics structure is described below as a dome, one skilled in the art would understand how the primary optics structure may have substantially any other shape or configuration, which encapsulates the emission LEDs and the at least one photodetector.

An exemplary emitter module 72 that may be included within the linear lamp 70 of Fig. 8A is shown in Fig. 8B . In the illustrated example useful for understanding the invention, emitter module 72 includes four differently colored emission LEDs 74, which are arranged in a square array and placed as close as possible together in the center of a primary optics structure (e.g., a dome) 76, so as to approximate a centrally located point source. In some embodiments, the emission LEDs 74 may each be configured for producing illumination at a different peak emission wavelength. For example, the emission LEDs 74 may include RGBW LEDs or RGBY LEDs. In addition to the emission LEDs 74, a dedicated photodetector 78 is included within the dome 76 and arranged somewhere around the periphery of the array. The dedicated photodetector 78 may be any device (such as a silicon photodiode or an LED) that produces current indicative of incident light.

In the example useful for understanding the invention, photodetector 78 is an LED with a peak emission wavelength in the range of approximately 550nm to 700nm. A photodetector with such a peak emission wavelength will not produce photocurrent in response to infrared light, which reduces interference from ambient light sources. In at least one preferred embodiment, photodetector 78 may comprise a small red, orange or yellow LED. In some embodiments, the dedicated photodetector 78 may be arranged to capture a maximum amount light, which is reflected from a surface of the dome 76 from the emission LEDs having the shortest wavelengths (e.g., the blue and green emission LEDs).

In the example useful for understanding the invention, the emitter module 72 may include a phosphor converted white (W) emission LED 74, and the dedicated photodetector 78 may be used to measure the photocurrents (Iph_d1) that are induced by the light that passes through the phosphor portion of the phosphor converted LED. In order to measure the photocurrents (Iph_d2) induced by the blue LED portion of the phosphor converted LED, the green emission LED 74 may be configured, at times, as an additional photodetector. These photocurrent measurements may be stored within the calibration table of Fig. 7

Figs. 9A and 9B illustrate a substantially different type of illumination device and emitter module design. Specifically, Fig. 9A depicts an illumination device 80 having a parabolic form factor (e.g., a PAR 38) and only one emitter module (not shown in Fig. 9A). As these illumination devices have only one emitter module, the emitter modules included in such devices typically include a plurality of differently colored chains of LEDs, where each chain includes two or more LEDs of the same color. Fig. 9B illustrates an exemplary emitter module 82 that may be included within the PAR lamp 80 shown in Fig. 9A .

In the illustrated example useful for understanding the invention, emitter module 82 includes an array of emission LEDs 84 and a plurality of dedicated photodetectors 88, all of which are mounted on a common substrate and encapsulated within a primary optics structure (e.g., a dome) 86. The array of emission LEDs 84 may include a number of differently colored chains of LEDS, wherein each chain is configured for producing illumination at a different peak emission wavelength. According to one embodiment, the array of emission LEDs 84 may include a chain of four red LEDs, a chain of four green LEDs, a chain of four blue LEDs, and a chain of four white or yellow LEDs. Each chain of LEDs is coupled in series and driven with the same drive current. The individual LEDs in each chain may be scattered about the array, and arranged so that no color appears twice in any row, column or diagonal, to improve color mixing within the emitter module 82.

In the example useful for understanding the invention shown in Fig. 9B , four dedicated photodetectors 88 are included within the dome 86 and arranged around the periphery of the array. The dedicated photodetectors 88 may be placed close to, and in the middle of, each edge of the array and may be connected in parallel to a receiver of the illumination device. By connecting the dedicated photodetectors 88 in parallel with the receiver, the photocurrents induced on each photodetector may be summed to minimize the spatial variation between the similarly colored LEDs, which may be scattered about the array. The dedicated photodetectors 88 may be any devices that produce current indicative of incident light (such as a silicon photodiode or an LED). In one example useful for understanding the invention, however, the dedicated photodetectors 88 are preferably LEDs with peak emission wavelengths in the range of 500nm to 700nm. Photodetectors with such peak emission wavelengths will not produce photocurrent in response to infrared light, which reduces interference from ambient light.

In an example useful for understanding the invention, emitter module 82 includes a phosphor converted white (W) emission LED 84 and two different colors of photodetectors for measuring different portions of the phosphor converted LED spectrum. In one example, the dedicated photodetectors 88 may include one or more small red LEDs and one or more small green LEDs. In such an example, the dedicated red photodetector(s) 88 may be used to measure the photocurrents (Iph_d1) that are induced by the light that passes through the phosphor portion of the phosphor converted LED, while the dedicated green photodetector(s) 88 are used to measure the photocurrents (Iph_d2) induced by the light emitted by blue LED portion of the phosphor converted LED. These photocurrent measurements (Iph_d1 and Iph_d2) may be stored within the calibration table of Fig. 7

The illumination devices shown in Figs. 8A and 9A and the emitter modules shown in Figs. 8B and 9B are provided merely as examples of illumination devices in which the improved calibration and compensation methods may be used. Further description of these illumination devices and emitter modules may be found in related U.S. Patent Application No. 14/097,339 and related U.S. Provisional Patent Application No. 61/886,471, However, the inventive concepts described herein are not limited to any particular type of LED illumination device, any particular number of emitter modules that may be included within an LED illumination device, or any particular number, color or arrangement of emission LEDs and photodetectors that may be included within an emitter module. Instead, the present invention may only require an LED illumination device to include at least one emitter module comprising a plurality of emission LEDs and at least one dedicated photodetector. In some embodiments, a dedicated photodetector may not be required, if one or more of the emission LEDs is configured, at times, to provide such functionality.

Fig. 10A is a side view of one an example useful for understanding the invention of an improved emitter module 90 comprising a plurality of emission LEDs 92 and one or more dedicated photodetectors 94, all of which are mounted on a common substrate 96 and encapsulated within a primary optics structure (e.g., a dome) 98. A heat sink 100 is coupled to a bottom surface of the substrate 96 for drawing heat away from the heat generating components of the emitter module 90. The heat sink 100 may comprise substantially any material with relatively high thermal and electrical conductivity. In some embodiments, the heat sink 100 is formed from a material having a thermal conductivity that ranges between about 200 W/(mK) and about 400 W/(mK). The heat sink is formed from a copper or copper-alloy material, or an aluminum or aluminum alloy material. The heat sink 100 may be a relatively thick layer ranging between about 1 mm and about 10 mm, and in one an example useful for understanding the invention, may be about 3 mm thick.

Emitter module 90 may include substantially any number and color of emission LEDs 92 and substantially any number and color of dedicated photodetectors 94. In one exemplary embodiment, the emission LEDs 92 include one or more red LEDs, one or more blue LEDs, one or more green LEDs and one or more white or yellow LEDs, as shown in Figs. 8B and 9B . The emission LEDs 92 may generally be arranged in an array near the center of the dome 98, and the dedicated photodetectors 94 may generally be arranged about a periphery of the array. In one exemplary embodiment, the dedicated photodetectors 94 may include one or more red, orange, yellow and/or green LEDs. The LEDs used to implement the dedicated photodetectors 94 are generally smaller than the emission LEDs 92, and are generally arranged to capture a maximum amount of light that is emitted from the emission LEDs 92 and reflected from the dome 98. In some embodiments, dedicated photodetectors 94 may be omitted if one or more of the emission LEDs 92 are configured, at times, for detecting incident light.

The primary optics structure 98 may be formed from a variety of different materials and may have substantially any shape and/or dimensions necessary to shape the light emitted by the emission LEDs in a desirable manner. Although the primary optics structure 98 is described herein as a dome, one skilled in the art would understand how the primary optics structure may have substantially any other shape or configuration, which encapsulates the emission LEDs 92 and the at least one photodetector 94. In an example useful for understanding the invention, the shape, size and material of the dome 98 may be generally designed to improve optical efficiency and color mixing within the emitter module 90.

In an example useful for understanding the invention, substrate 96 may comprise a laminate material such as a printed circuit board (PCB) FR4 material, or a metal clad PCB material. However, substrate 96 may be formed from a ceramic material (or some other optically reflective material), in an example useful for understanding the invention, so that the substrate may generally function to improve output efficiency by reflecting light back out of the emitter module 90. In addition, substrate 96 may be configured to provide a relatively high thermal impedance, or low thermal conductivity, in the lateral direction (i.e., the direction in the plane of the substrate). In an example useful for understanding the invention, an example useful for understanding the invention substrate 96 may be formed from a material (e.g., aluminum nitride, A1N) having a thermal conductivity less than or equal to about 150 W/(mK). In another example useful for understanding the invention, substrate 96 may be formed from a material (e.g., an aluminum oxide Al₂O₃ material) having a thermal conductivity less than about 30 W/(mK), or material (e.g., a PCB laminate material) having a thermal conductivity less than about 1 W/(mK). The high thermal impedance, or low thermal conductivity, provided by substrate 96 in the lateral direction advantageously isolates the junction temperatures of the emission LEDs 92 and the photodetectors 94, and avoids inaccurate Vfe and Vfd measurements.

In an example useful for understanding the invention, substrate 96 may be further configured to provide a relatively low thermal impedance, or high thermal conductivity, in the vertical direction (i.e., the direction perpendicular to the plane of the substrate). In particular, a relatively low thermal impedance path 102 may be provided between each emission LED 92 and each photodetector 94 to the heat sink 100. In addition to improving heat dissipation, the low thermal impedance paths 102 enable the substrate 96 to maintain a consistent temperature difference between the emitter and detector junction temperatures over operating conditions.

The improved emitter module 90 shown in Fig. 10A maintains a relatively fixed temperature difference between the emission LEDs 92 and the dedicated photodetectors 94 by providing each of the emission LEDs 92 and each of the photodetectors 94 with a low thermal impedance path 102 to the heat sink 100. This may be achieved in a number of different ways. In the example useful for understanding the invention shown in Fig. 10A, a low thermal impedance path 102 is provided by minimizing the thickness of the substrate 96 (which minimizes the vertical distance between the emission LEDs 92, the photodetectors 94 and the heat sink 100), and by connecting each of the emission LEDs 92 and each of the photodetectors 94 to the heat sink 100 with a plurality of thermally conductive lines 102. In one example, the thickness (T) of substrate 96 may range between about 300µm and about 500 µm.

In general, the plurality of thermally conductive lines 102 may comprise substantially any thermally conductive material. In some embodiments, the thermally conductive lines 102 are formed from a material having a thermal conductivity that ranges between about 200 W/(mK) and about 400 W/(mK). The material used for the thermally conductive lines 102 may be the same material used for the heat sink 100, or may be different. In an example useful for understanding the invention, the thermally conductive lines 102 are formed from an aluminum, aluminum-alloy, copper or copper-alloy material. The plurality of thermally conductive lines 102 may be formed by drilling vertical holes through the substrate (using any mechanical or optical means), and filling or plating the holes (or vias) with a metal material using any appropriate method. In an example useful for understanding the invention, each thermally conductive line 102 may comprise a plurality (e.g., about 10-20) of densely packed vias, with each via being on the order of a couple of hundred microns wide.

While the emitter module shown in Fig. 10A provides desirable thermal characteristics, it may not provide sufficient electrical isolation between the emission LEDs, photodetectors and heat sink. For both the emission LEDs and the photodetectors, the electrical contacts to either the anode, cathode, or both (in a flip-chip LED design) are generally provided on the backside of the LEDs. These contacts cannot be electrically coupled to the heat sink by directly connecting the contacts to the heat sink with the metal lines shown in Fig. 10A. In order to provide electrical isolation between the LEDs and the heat sink, routing layers are provided in Fig. 10B for connecting a chain of LEDs together and for connecting the LED anodes/cathodes to external contacts outside of the dome.

Fig. 10B is a side view of another an example useful for understanding the invention of an improved emitter module 110 comprising a plurality of emission LEDs 92 and one or more dedicated photodetectors 94, all of which are mounted on a common substrate 112 and encapsulated within a primary optics structure 98. Many of the components shown in Fig. 10B are similar to those shown in Fig. 10A. Like components are denoted with like reference numerals.

Emitter module 110 may include substantially any number, color and arrangement of emission LEDs 92 and substantially any number, color and arrangement of dedicated photodetectors 94. The emission LEDs 92 and the dedicated photodetectors 94 may be similar to those described above, but are not limited to such. In some embodiments, one or more of the dedicated photodetectors 94 may be omitted if one or more of the emission LEDs 92 are configured, at times, for detecting incident light.

The primary optics structure 98 may be formed from a variety of different materials and may have substantially any shape and/or dimensions necessary to shape the light emitted by the emission LEDs 92 in a desirable manner. Although the primary optics structure 98 is described herein as a dome, one skilled in the art would understand how the primary optics structure may have substantially any other shape or configuration, which encapsulates the emission LEDs 92 and the at least one photodetector 94. In an example useful for understanding the invention, the shape, size and material of the dome 98 may be generally designed to improve optical efficiency and color mixing within the emitter module 110.

Heat sink 100 is coupled to a bottom surface of the substrate 112 for drawing heat away from the heat generating components of the emitter module 110. The heat sink 100 may comprise substantially any material with relatively high thermal and electrical conductivity. In some embodiments, heat sink 100 is formed from a material having a thermal conductivity that ranges between about 200 W/(mK) and about 400 W/(mK). In one embodiment, the heat sink is formed from a copper or copper-alloy material, or an aluminum or aluminum alloy material. In some embodiments, the heat sink 100 may be a relatively thick layer ranging between about 1 mm and about 10 mm, and in one an example useful for understanding the invention, may be about 3 mm thick.

Emitter module 110 differs from emitter module 90, in at least one aspect, by electrically isolating the electrical contacts of the emission LEDs 92 and the photodetectors 94 from the heat sink 100. This is achieved in the an example useful for understanding the invention of Fig. 10B by utilizing a substrate 112 having multiple layers. While an overall thickness (e.g., about 300 µm to about 500 µm) of the multiple layer substrate 112 may be similar to the single layer substrate 96 shown in Fig. 10A, in an example useful for understanding the invention, the multiple layer substrate 112 shown in Fig. 10B is generally formed to include multiple routing and dielectric layers, which not only provide electrical isolation between the electrical contacts of the LEDs and the heat sink, but also improve routing flexibility.

According to an example useful for understanding the invention, multiple layer substrate 112 may include a first routing layer 114, a first dielectric layer 116, a second routing layer 118 and a second dielectric layer 120. The first routing layer 114 is coupled to the electrical contacts of the emission LEDs 92 and the one or more photodetectors 94, and may be formed on the first dielectric layer 116. The first routing layer 114 may have a thickness that ranges between about 10 µm to about 20 µm, may be formed of a material (e.g., a copper or aluminum material, or an alloy thereof) having a thermal conductivity that ranges between 200 W/(mK) and about 400 W/(mK), and may be formed by any well-known process on the upper surface of the first dielectric layer 116. For example, the first routing layer 114 may be formed by printing or depositing metal lines on the upper surface of the first dielectric layer 116.

The first dielectric layer 116 is sandwiched between the first routing layer 114 and the second routing layer 118 for electrically isolating the electrical contacts of the LEDs from the heat sink 100. In an example useful for understanding the invention, the first dielectric layer 116 may be a relatively thin layer having a thickness between about 10 µm and about 100 µm, and may be formed from a dielectric material having a relative permittivity that ranges between about 3 and 12. In one example, the first dielectric layer 116 may be formed from an aluminum nitride material or an aluminum oxide material, but is not limited to such materials.

In addition to providing electrical isolation, first dielectric layer 116 provides a relatively high thermal impedance in the lateral direction by using a material with a relatively low thermal conductivity, which is less than about 150 W/(mK), and keeping the thickness of the layer small relative to the spacing between the emission LEDs and the photodetectors. In an example useful for understanding the invention, the first dielectric layer 116 may have a thickness of about 30 µm, and the emission LEDs 92 and photodetectors 94 may be spaced at least 200-300 µm apart on an upper surface of the substrate 112. Such an example would provide at least 10 times higher thermal conductivity in the vertical direction than in the lateral direction.

The second routing layer 118 is coupled between the first dielectric layer 116 and the second dielectric layer 120 and is generally configured for routing signals between the first routing layer 114 and external electrical contacts (not shown) arranged outside of the primary optics structure. Like the first routing layer 114, the second routing layer 118 may have a thickness that ranges between about 10 µm to about 20 µm, may be formed of a material (e.g., a copper or aluminum material, or an alloy thereof) having a thermal conductivity that ranges between 200 W/(mK) and about 400 W/(mK), and may be formed by any well-known process on the upper surface of the second dielectric layer 120. For example, the second routing layer 118 may be formed by printing or depositing metal lines on the upper surface of the second dielectric layer 120. In order to route signals between the first routing layer 114 and the second routing layer 118, vias 124 may be formed within the first dielectric layer 116. These vias may be formed in accordance with any known process.

In an example useful for understanding the invention, the second dielectric layer 120 may be coupled between the second routing layer 118 and the heat sink 100 and may be generally configured for providing a relatively high thermal impedance in the lateral direction, and a relatively low thermal impedance in the vertical direction. The second dielectric layer 120 may be a relatively thick layer having a thickness between about 100 µm and about 1000 µm, which The imparts rigidity to the emitter module 110. The second dielectric layer 120 may be formed from a dielectric material having a relative permittivity that ranges between about 3 and 12 and a thermal conductivity that is less than about 150 W/(mK). In one example, the second dielectric layer 120 may be formed from an aluminum nitride material or an aluminum oxide material, but is not limited to such materials.

The second dielectric layer 120 is similar to the substrate 96 shown in Fig. 10A, in that it provides a relatively high thermal impedance in the lateral direction by implementing the second dielectric layer 120 with a material having a thermal conductivity less than about 150 W/(mK), and a relatively low thermal impedance in the vertical direction by including a plurality of thermally conductive lines 122, which extend vertically through the second dielectric layer 120 between the second routing layer 118 and the heat sink 100. As noted above, the plurality of thermally conductive lines 122 may be formed from a material having a thermal conductivity that ranges between about 200W/(mK) and about 400 W/(mK), such as a copper or aluminum material, or an alloy thereof. The plurality of thermally conductive lines 122 may be formed by drilling vertical holes through the second dielectric layer (using any mechanical or optical means), and filling or plating the holes (or vias) with an appropriate metal material using any appropriate method. In some embodiments, each thermally conductive line 122 may comprise a plurality (e.g., about 10-20) of densely packed vias, with each via being a couple of hundred microns wide.

In an example useful for understanding the invention, a third routing layer 126 may be coupled between the second dielectric layer 120 and the heat sink 100. Unlike the first and second routing layers, which comprise metal lines printed on the first and second dielectric layers, the third routing layer 126 may extend substantially continuously across an upper surface of the heat sink 100 for improving the thermal contact between the plurality of thermally conductive lines 122 and the heat sink 100 and improving heat spreading there across.

Like the substrate 96 shown in Fig. 10A, the multiple layer substrate 112 shown in Fig. 10B provides good thermal isolation between the emission LEDs 92, and between the emission LEDs and the photodetectors, while providing rigidity and maintaining good overall thermal conductivity to the heat sink 100.

The multiple layer substrate 112 shown in Fig. 10B also provides other advantages, which the single layer substrate 96 cannot provide. For example, substrate 112 includes multiple routing and dielectric layers, which improve routing flexibility for connecting chains of the emission LEDs 92 together, and provides electrical isolation between the electrical contacts of the emission LEDs and photodetectors and the heat sink 100.

The multiple layer substrate 112 can also be implemented somewhat differently in alternative embodiments of the invention. For example, instead of using dielectric or ceramic materials for layers 116 and 120, these layers could be using a laminate material such as a printed circuit board (PCB) FR4 material, or a metal clad PCB material. However, since the thermal conductivity of laminate materials (e.g., less than about 1 W/(mK)) is much less than that of ceramic materials, using a laminate material in lieu of a ceramic material would reduce the thermal conductivity of layer 120. Regardless of the material used for layer 120, thermal conductivity may be increased in some embodiments of the invention by increasing the number of thermally conductive lines 122 included under the LED array. While this approach would provide better overall thermal conductivity from the LED array to the heat sink, it would provide worse thermal separation between the emission LEDs.

Fig. 11 is one example of a block diagram of an illumination device 110 configured to accurately maintain a desired luminous flux and a desired chromaticity over variations in drive current, temperature and time. The illumination device illustrated in Fig. 11 provides one example of the hardware and/or software that may be used to implement the calibration method shown in Fig. 6

In the illustrated an example useful for understanding the invention, illumination device 110 comprises a plurality of emission LEDs 126 and one or more dedicated photodetectors 128. The emission LEDs 126, in this example, comprise four chains of any number of LEDs. In an example useful for understanding the invention, each chain may have 2 to 4 LEDs of the same color, which are coupled in series and configured to receive the same drive current. In one example, the emission LEDs 126 may include a chain of red LEDs, a chain of green LEDs, a chain of blue LEDs, and a chain of white or yellow LEDs. However, the present invention is not limited to any particular number of LED chains, any particular number of LEDs within the chains, or any particular color or combination of LED colors.

Although the one or more dedicated photodetectors 128 are also illustrated in Fig. 11 as including a chain of LEDs, the present invention is not limited to any particular type, number, color, combination or arrangement of photodetectors. In an example useful for understanding the invention, the one or more dedicated photodetectors 128 may include a small red, orange or yellow LED, as discussed above with respect to Fig. 8B . In another example useful for understanding the invention, the one or more dedicated photodetectors 128 may include one or more small red LEDs and one or more small green LEDs, as discussed above with respect to Fig. 9B . In an example useful for understanding the invention, one or more of the dedicated photodetector(s) 128 shown in Fig. 11 may be omitted if one or more of the emission LEDs 126 are configured, at times, to function as a photodetector. The plurality of emission LEDs 126 and the (optional) dedicated photodetectors 128 may be included within an emitter module, as discussed above. In some embodiments, an illumination device may include more than one emitter module, as discussed above.

In addition to including one or more emitter modules, illumination device 110 includes various hardware and software components, which are configured for powering the illumination device and controlling the light output from the emitter module(s) an example useful for understanding the invention, the illumination device is connected to an AC mains 112, and includes an AC/DC converter 114 for converting AC mains power (e.g., 120V or 240V) to a DC voltage (V_{DC}). As shown in Fig. 11 this DC voltage (e.g., 15V) is supplied to the LED driver and receiver circuit 124 for producing the operative drive currents applied to the emission LEDs 126 for producing illumination. In addition to the AC/DC converter, a DC/DC converter 116 is included for converting the DC voltage V_{DC} (e.g., 15V) to a lower voltage V_{L} (e.g., 3.3V), which is used to power the low voltage circuitry included within the illumination device, such as PLL 118, wireless interface 120, and control circuit 122.

In the illustrated example useful for understanding the invention, PLL 118 locks to the AC mains frequency (e.g., 50 or 60 HZ) and produces a high speed clock (CLK) signal and a synchronization signal (SYNC). The CLK signal provides the timing for control circuit 122 and LED driver and receiver circuit 124. In one example, the CLK signal frequency is in the tens of mHz range (e.g., 23MHz), and is precisely synchronized to the AC Mains frequency and phase. The SNYC signal is used by the control circuit 122 to create the timing used to obtain the various optical and electrical measurements described above. In one example, the SNYC signal frequency is equal to the AC Mains frequency (e.g., 50 or 60 HZ) and also has a precise phase alignment with the AC Mains.

In an example useful for understanding the invention, a wireless interface 120 may be included and used to calibrate the illumination device 110 during manufacturing. As noted above, for example, an external calibration tool (not shown in Fig. 11) may communicate luminous flux and chromaticity calibration values to an illumination device under test via the wireless interface 120. The calibration values received via the wireless interface 120 may be stored in the table of calibration values within a storage medium 121 of the control circuit 122, for example. In an example useful for understanding the invention, the control circuit 122 may use the calibration values to generate calibration coefficients, which are stored within the storage medium 121 in addition to, or in lieu of, the received calibration values.

Wireless interface 120 is not limited to receiving only calibration data, and may be used for communicating information and commands for many other purposes. For example, wireless interface 120 could be used during normal operation to communicate commands, which may be used to control the illumination device 110, or to obtain information about the illumination device 110. For instance, commands may be communicated to the illumination device 110 via the wireless interface 120 to turn the illumination device on/off, to control the dimming level and/or color set point of the illumination device, to initiate the calibration procedure, or to store calibration results in memory. In other examples, wireless interface 120 may be used to obtain status information or fault condition codes associated with illumination device 110.

In an example useful for understanding the invention, wireless interface 120 could operate according to ZigBee, WiFi, Bluetooth, or any other proprietary or standard wireless data communication protocol. In other embodiments, wireless interface 120 could communicate using radio frequency (RF), infrared (IR) light or visible light. In alternative embodiments, a wired interface could be used, in place of the wireless interface 120 shown, to communicate information, data and/or commands over the AC mains or a dedicated conductor or set of conductors.

Using the timing signals received from PLL 118, the control circuit 122 calculates and produces values indicating the desired drive current to be used for each LED chain 126. This information may be communicated from the control circuit 122 to the LED driver and receiver circuit 124 over a serial bus conforming to a standard, such as SPI or I²C, for example. In addition, the control circuit 122 may provide a latching signal that instructs the LED driver and receiver circuit 124 to simultaneously change the drive currents supplied to each of the LEDs 126 to prevent brightness and color artifacts.

In general, the control circuit 122 may be configured for determining the respective drive currents needed to achieve a desired luminous flux and/or a desired chromaticity for the illumination device In some embodiments, the control circuit 122 may determine the respective drive currents by executing program instructions stored within the storage medium 121. In an example useful for understanding the invention, the storage medium may be a non-volatile memory, and may be configured for storing the program instructions along with a table of calibration values, such as the table described above with respect to Fig. 7. Alternatively, the control circuit 122 may include combinatorial logic for determining the desired drive currents, and the storage medium 121 may only be used for storing the table of calibration values.

In general, the LED driver and receiver circuit 124 may include a number (N) of driver blocks 130 equal to the number of emission LED chains 126 included within the illumination device. In the example useful for understanding the invention, discussed herein, LED driver and receiver circuit 124 comprises four driver blocks 130, each configured to produce illumination from a different one of the emission LED chains 126. The LED driver and receiver circuit 124 also comprises the circuitry needed to measure ambient temperature (optional), the detector and/or emitter forward voltages, and the detector photocurrents, and to adjust the LED drive currents accordingly. Each driver block 130 receives data indicating a desired drive current from the control circuit 122, along with a latching signal indicating when the driver block 130 should change the drive current.

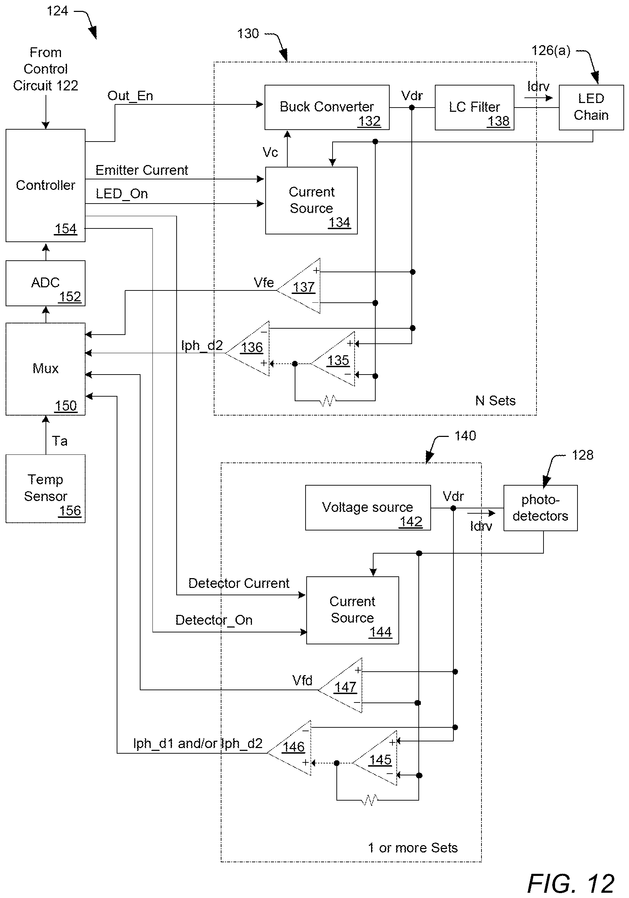

Fig. 12 is an exemplary block diagram of an LED driver and receiver circuit 124, according to an example useful for understanding the invention. As shown in Fig. 12, the LED driver and receiver circuit 124 includes four driver blocks 130, each block including a buck converter 132, a current source 134, and an LC filter 138 for generating the drive currents that are supplied to a connected chain of emission LED 126a to produce illumination and obtain forward voltage (Vfe) measurements. In an example useful for understanding the invention, buck converter 132 may produce a pulse width modulated (PWM) voltage output (Vdr) when the controller 154 drives the "Out_En" signal high. This voltage signal (Vdr) is filtered by the LC filter 138 to produce a forward voltage on the anode of the connected LED chain 126a. The cathode of the LED chain is connected to the current source 134, which forces a fixed drive current equal to the value provided by the "Emitter Current" signal through the LED chain 126a when the "Led On" signal is high. The "Vc" signal from the current source 134 provides feedback to the buck converter 132 to output the proper duty cycle and minimize the voltage drop across the current source 134.

As shown in Fig. 12, each driver block 130 includes a difference amplifier 137 for measuring the forward voltage drop (Vfe) across the chain of emission LEDs 126a. When measuring Vfe, the buck converter 132 is turned off and the current source 134 is configured for drawing a relatively small drive current (e.g., about 1mA) through the connected chain of emission LEDs 126a. The voltage drop (Vfe) produced across the LED chain 126a by that current is measured by the difference amplifier 137. The difference amplifier 137 produces a signal that is equal to the forward voltage (Vfe) drop across the emission LED chain 126a during forward voltage measurements.

As noted above, an example useful for understanding the invention may use one of the emission LEDs (e.g., a green emission LED), at times, as a photodetector. In such example , the driver blocks 130 may include additional circuitry for measuring the photocurrents (Iph_d2), which are induced across an emission LED, when the emission LED is configured for detecting incident light. For example, each driver block 130 may include a transimpedance amplifier 135, which generally functions to convert an input current to an output voltage proportional to a feedback resistance. As shown in Fig. 12, the positive terminal of transimpedance amplifier 135 is connected to the Vdr output of the buck converter 132, while the negative terminal is connected to the cathode of the last LED in the LED chain 126a. Transimpedance amplifier 135 is enabled when the "LED_On" signal is low. When the "LED On" signal is high, the output of transimpedance amplifier 135 is tri-stated.

When measuring the photocurrents (Iph_d2) induced by an emission LED, the buck converters 132 connected to all other emission LEDs should be turned off to avoid visual artifacts produced by LED current transients. In addition, the buck converter 132 coupled to the emission LED under test should also be turned off to prevent switching noise within the buck converter from interfering with the photocurrent measurements. Although turned off, the Vdr output of the buck converter 132 coupled to the emission LED under test is held to a particular value (e.g., about 2-3.5 volts times the number of emission LEDs in the chain) by the capacitor within LC filter 138. When this voltage (Vdr) is supplied to the anode of emission LED under test and the positive terminal of the transimpedance amplifier 135, the transimpedance amplifier produces an output voltage (relative to Vdr) that is supplied to the positive terminal of difference amplifier 136. Difference amplifier 136 compares the output voltage of transimpedance amplifier 135 to Vdr and generates a difference signal, which corresponds to the photocurrent (Iph_d2) induced across the LED chain 126a.

In addition to including a plurality of driver blocks 130, the LED driver and receiver circuit 124 may include one or more receiver blocks 140 for measuring the forward voltages (Vfd) and photocurrents (Iph_d1 or Iph_d2) induced across the one or more dedicated photodetectors 128. Although only one receiver block 140 is shown in Fig. 12, the LED driver and receiver circuit 124 may generally include a number of receiver blocks 140 equal to the number of dedicated photodetectors included within the emitter module.

In the illustrated example useful for understanding the invention, receiver block 140 comprises a voltage source 142, which is coupled for supplying a DC voltage (Vdr) to the anode of the dedicated photodetector 128 coupled to the receiver block, while the cathode of the photodetector 128 is connected to current source 144. When photodetector 128 is configured for obtaining forward voltage (Vfd), the controller 154 supplies a "Detector On" signal to the current source 144, which forces a fixed drive current (Idrv) equal to the value provided by the "Detector Current" signal through photodetector 128.

When obtaining detector forward voltage (Vfd) measurements, current source 144 is configured for drawing a relatively small amount of drive current (Idrv) through photodetector 128. The voltage drop (Vfd) produced across photodetector 128 by that current is measured by difference amplifier 147, which produces a signal equal to the forward voltage (Vfd) drop across photodetector 128. As noted above, the drive current (Idrv) forced through photodetector 128 by the current source 144 is generally a relatively small, non-operative drive current. In the embodiment in which four dedicated photodetectors 128 are coupled in parallel, the non-operative drive current may be roughly 1mA. However, smaller/larger drive currents may be used in an example useful for understanding the invention that include fewer/greater numbers of photodetectors, or embodiments that do not connect the photodetectors in parallel.

Similar to driver block 130, receiver block 140 also includes circuitry for measuring the photocurrents (Iph_d1 or Iph_d2) induced on photodetector 128 by light emitted by the emission LEDs. As shown in Fig. 12, the positive terminal of transimpedance amplifier 145 is coupled to the Vdr output of voltage source 142, while the negative terminal is connected to the cathode of photodetector 128. When connected in this manner, the transimpedance amplifier 145 produces an output voltage relative to Vdr (e.g., about 0-1V), which is supplied to the positive terminal of difference amplifier 146. Difference amplifier 146 compares the output voltage to Vdr and generates a difference signal, which corresponds to the photocurrent (Iph_d1 or Iph_d2) induced across photodetector 128. Transimpedance amplifier 145 is enabled when the "Detector_On" signal is low. When the "Detector_On" signal is high, the output of transimpedance amplifier 145 is tri-stated.

As noted above, an example useful for understanding the invention may scatter the individual LEDs within each chain of LEDs 126 about the array of LEDs, so that no two LEDs of the same color exist in any row, column or diagonal (see, e.g., Fig. 9B). By connecting a plurality of dedicated photodetectors 128 in parallel with the receiver block 140, the photocurrents (Iph_d1 or Iph_d2) induced on each photodetector 128 by the LEDs of a given color may be summed to minimize the spatial variation between the similarly colored LEDs, which are scattered about the array.

As shown in Fig. 12 , the LED driver and receiver circuit 124 may also include a multiplexor (Mux) 150, an analog to digital converter (ADC) 152, a controller 154, and an optional temperature sensor 156. In some an example useful for understanding the invention, multiplexor 150 may be coupled for receiving the emitter forward voltage (Vfe) and the (optional) photocurrent (Iph_d2) measurements from the driver blocks 130, and the detector forward voltage (Vfd) and detector photocurrent (Iph_d1 and/or Iph_d2) measurements from the receiver block 140. The ADC 152 digitizes the emitter forward voltage (Vfe) and the optional photocurrent (Iph_d2) measurements output from the driver blocks 130, and the detector forward voltage (Vfd) and detector photocurrent (Iph_d1 and/or Iph_d2) measurements output from the receiver block 140, and provides the results to the controller 154. The controller 154 determines when to take forward voltage and photocurrent measurements and produces the Out_En, Emitter Current and Led_On signals, which are supplied to the driver blocks 130, and the Detector Current and Detector_On signals, which are supplied to the receiver block 140 as shown in Fig. 12.

In an example useful for understanding the invention, the LED driver and receiver circuit 124 may include an optional temperature sensor 156 for taking ambient temperature (Ta) measurements. In such example , multiplexor 150 may also be coupled for multiplexing the ambient temperature (Ta) with the forward voltage and photocurrent measurements sent to the ADC 152. In some embodiments, the temperature sensor 156 may be a thermistor, and may be included on the driver circuit chip for measuring the ambient temperature surrounding the LEDs, or a temperature from the heat sink of the emitter module. In an example useful for understanding the invention, the temperature sensor 156 may be an LED, which is used as both a temperature sensor and an optical sensor to measure ambient light conditions or output characteristics of the LED emission chains 126.

One implementation of an improved illumination device 110 has now been described in reference to Figs. 11-12. Further description of such an illumination device may be found in commonly assigned U.S. Application Serial Nos. 13/970,944, 13/970,964 and 13/970,990. A skilled artisan would understand how the illumination device could be alternatively implemented within the scope of the present invention.

It will be appreciated to those skilled in the art having the benefit of this disclosure that this invention is believed to provide an improved illumination device and improved methods for calibrating and compensating individual LEDs in the illumination device, so as to maintain a desired luminous flux and a desired chromaticity over variations in drive current, temperature and time. In addition, emitter modules having improved thermal and electrical characteristics are also provided herein.

## Claims

1. A method for calibrating an illumination device comprising a first light emitting diode - hereinafter abbreviated LED - and a photodetector, the method comprising:
subjecting (10) the illumination device to a first ambient temperature;
successively applying (12) at least three different drive currents to the first LED to produce illumination at three or more different levels of brightness;
obtaining (14) a plurality of optical measurements from the illumination produced by the first LED at each of the at least three different drive currents, wherein the plurality of optical measurements comprise luminous flux and chromaticity;
obtaining (16) a plurality of electrical measurements from the photodetector, wherein the plurality of electrical measurements comprise a plurality of photocurrents, which arc induced on the photodetector by the illumination produced by the first LED at each of the at least three different drive currents, and forward voltages that are measured across the photodetector before, during or after each induced photocurrent is measured; and
storing (22) the plurality of optical measurements resulting from the step of obtaining a plurality of optical measurements and the plurality of electrical measurements resulting from the step of obtaining a plurality of electrical measurements within the illumination device to calibrate the first LED at the first ambient temperature.

2. The method as recited in claim 1, wherein each of the forward voltages is measured across the photodetector by applying a non-operative drive current to the photodetector.

3. The method as recited in claim 2, wherein the non-operative drive current applied to the photodetector ranges between approximately 100 µA and approximately 1mA.

4. The method as recited in claim 1, wherein before, during or after each induced photocurrent is measured, the method further comprises applying a non-operative drive current to the first LED and measuring a forward voltage that develops across the anode and cathode of the first LED.

5. The method as recited in claim 4, wherein the non-operative drive current applied to the first LED ranges between approximately 0.1 mA and approximately 10 mA.

6. The method as recited in claim 1, further comprising:
subjecting (18) the first LED to a second ambient temperature, which is different from the first ambient temperature; and
repeating (20) the steps of successively applying at least three different drive currents to the first LED, obtaining a plurality of optical measurements from the illumination produced by the first LED at each of the at least three different drive currents, obtaining a plurality of electrical measurements from the photodetector, and storing results of the obtaining steps to calibrate the first LED at the second ambient temperature.

7. The method as recited in claim 6, wherein the illumination device comprises a plurality of LEDs including the first LED, and wherein the method is performed for each of the plurality of LEDs.

8. The method as recited in claim 1, wherein the at least three different drive currents comprise a first operative drive current that is substantially equal to a maximum drive current associated with the first LED, a second operative drive current that is substantially less than the first operative drive current, and a third operative drive current that is substantially less than the second operative drive current.

9. The method as recited in claim 1, wherein the illumination device comprises an additional photodetector, wherein the method further comprises obtaining a plurality of electrical measurements from the additional photodetector, wherein the plurality of electrical measurements comprise a plurality of photocurrents, which are induced on the additional photodetector by the illumination produced by the first LED at each of the at least three different drive currents, and a plurality of forward voltages that are measured across the additional photodetector before, during or after each induced photocurrent is measured.

10. The method as recited in claim 9, wherein the first LED is a phosphor converted LED, wherein the plurality of photocurrents induced on the photodetector by the illumination produced by the phosphor converted LED correspond to a first portion of a spectrum of the phosphor converted LED, wherein the plurality of photocurrents induced on the additional photodetector by the illumination produced by the phosphor converted LED correspond to a second portion of the spectrum of the phosphor converted LED, and wherein the first portion and second portion comprise substantially different peak wavelengths.

## Patentansprüche

1. Verfahren zur Kalibrierung einer Beleuchtungsvorrichtung, die eine erste lichtemittierende Diode - nachfolgend kurz: LED - und einen Fotodetektor umfasst, wobei das Verfahren Folgendes umfasst:
Aussetzen (10) der Beleuchtungsvorrichtung einer ersten Umgebungstemperatur;
aufeinanderfolgendes Anlegen (12) von mindestens drei unterschiedlichen Antriebsströmen an die erste LED zum Erzeugen von Beleuchtung bei drei oder mehr unterschiedlichen Helligkeitsstufen;
Erhalten (14) einer Vielzahl von optischen Messungen von der von der ersten LED bei jedem der mindestens drei unterschiedlichen Antriebsströme erzeugten Beleuchtung, wobei die Vielzahl von optischen Messungen Lichtfluss und Farbwert umfasst;
Erhalten (16) einer Vielzahl von elektrischen Messungen vom Fotodetektor, wobei die Vielzahl von elektrischen Messungen eine Vielzahl von Fotoströmen umfasst, die auf dem Fotodetektor von der von der ersten LED bei jedem der mindestens drei unterschiedlichen Antriebsströme erzeugten Beleuchtung induziert werden, und Durchlassspannungen, die über den Fotodetektor gemessen werden, bevor, während oder nachdem jeder induzierte Fotostrom gemessen wird; und
Speichern (22) der Vielzahl von optischen Messungen, die sich aus dem Schritt des Erhaltens einer Vielzahl von optischen Messungen ergeben, und der Vielzahl von elektrischen Messungen, die sich aus dem Schritt des Erhaltens einer Vielzahl von elektrischen Messungen innerhalb der Beleuchtungsvorrichtung ergeben, zum Kalibrieren der ersten LED bei der ersten Umgebungstemperatur.

2. Verfahren nach Anspruch 1, wobei jede der Durchlassspannungen über den Fotodetektor durch Anlegen eines Fehlantriebsstroms an den Fotodetektor gemessen wird.

3. Verfahren nach Anspruch 2, wobei sich der an den Fotodetektor angelegte Fehlantriebsstrom zwischen etwa 100 µA and etwa 1 mA bewegt.

4. Verfahren nach Anspruch 1, wobei, bevor, während oder nachdem jeder induzierte Fotostrom gemessen wird, das Verfahren ferner Anlegen eines Fehlantriebsstroms an die erste LED und Messen einer Durchlassspannung umfasst, die über die Anode und Kathode der ersten LED entsteht.

5. Verfahren nach Anspruch 4, wobei sich der an die erste LED angelegte Fehlantriebsstrom zwischen etwa 0,1 mA und etwa 10 mA bewegt.

6. Verfahren nach Anspruch 1, das ferner Folgendes umfasst:
Aussetzen (18) der ersten LED einer zweiten Umgebungstemperatur, die sich von der ersten Umgebungstemperatur unterscheidet; und
Wiederholen (20) der folgenden Schritte: aufeinanderfolgendes Anlegen von mindestens drei unterschiedlichen Antriebsströmen an die erste LED, Erhalten einer Vielzahl von optischen Messungen von der von der ersten LED bei jedem der mindestens drei unterschiedlichen Antriebsströme erzeugten Beleuchtung, Erhalten einer Vielzahl von elektrischen Messungen vom Fotodetektor und Speichern von Ergebnissen der Schritte des Erhaltens zum Kalibrieren der ersten LED bei der zweiten Umgebungstemperatur.

7. Verfahren nach Anspruch 6, wobei die Beleuchtungsvorrichtung eine Vielzahl von LEDs umfasst, die die erste LED beinhaltet, und wobei das Verfahren für jede der Vielzahl von LEDs durchgeführt wird.

8. Verfahren nach Anspruch 1, wobei die mindestens drei unterschiedlichen Antriebsströme einen ersten Ansprechantriebsstrom, der im Wesentlichen gleich einem maximalen, mit der ersten LED assoziierten Antriebsstrom ist, einen zweiten Ansprechantriebsstrom, der im Wesentlichen geringer als der erste Ansprechantriebsstrom ist, und einen dritten Ansprechantriebsstrom, der im Wesentlichen geringer als der zweite Ansprechantriebsstrom ist, umfassen.

9. Verfahren nach Anspruch 1, wobei die Beleuchtungsvorrichtung einen zusätzlichen Fotodetektor umfasst, wobei das Verfahren ferner Erhalten einer Vielzahl von elektrischen Messungen vom zusätzlichen Fotodetektor umfasst, wobei die Vielzahl von elektrischen Messungen eine Vielzahl von Fotoströmen umfasst, die auf dem zusätzlichen Fotodetektor von der von der ersten LED bei jedem der mindestens drei unterschiedlichen Antriebsströme erzeugten Beleuchtung induziert werden, und eine Vielzahl von Durchlassspannungen, die über den zusätzlichen Fotodetektor gemessen werden, bevor, während oder nachdem jeder induzierte Fotostrom gemessen wird.

10. Verfahren nach Anspruch 9, wobei die erste LED eine Phosphor-konvertierte LED ist, wobei die Vielzahl von Fotoströmen, die auf dem Fotodetektor von der von der Phosphor-konvertierten LED erzeugten Beleuchtung induziert werden, einem ersten Abschnitt eines Spektrums der Phosphor-konvertierten LED entspricht, wobei die Vielzahl von Fotoströmen, die auf dem zusätzlichen Fotodetektor von der von der Phosphor-konvertierten LED erzeugten Beleuchtung induziert werden, einem zweiten Abschnitt des Spektrums der Phosphor-konvertierten LED entspricht, und wobei der erste Abschnitt und der zweite Abschnitt im Wesentlichen unterschiedliche Wellenlängen umfassen.

## Revendications

1. Procédé d'étalonnage d'un dispositif d'éclairage comprenant une première diode électroluminescente - ci-après abrégée DEL - et un photodétecteur, le procédé comprenant :
le fait de soumettre (10) le dispositif d'éclairage à une première température ambiante ;
l'application successive (12) d'au moins trois courants d'excitation différents à la première DEL pour produire un éclairage à trois niveaux de luminosité différents ou plus ;
l'obtention (14) d'une pluralité de mesures optiques à partir de l'éclairage produit par la première DEL à chacun des au moins trois courants d'excitation différents, dans lequel la pluralité de mesures optiques comprend le flux lumineux et la chromaticité ;
l'obtention (16) d'une pluralité de mesures électriques à partir du photodétecteur, dans lequel la pluralité de mesures électriques comprend une pluralité de photocourants, qui sont induits sur le photodétecteur par l'éclairage produit par la première DEL à chacun des au moins trois courants d'excitation différents, et des tensions directes qui sont mesurées à travers le photodétecteur avant, pendant ou après la mesure de chaque photocourant induit ; et
le stockage (22) de la pluralité de mesures optiques résultant de l'étape d'obtention d'une pluralité de mesures optiques et de la pluralité de mesures électriques résultant de l'étape d'obtention d'une pluralité de mesures électriques à l'intérieur du dispositif d'éclairage pour étalonner la première DEL à la première température ambiante.

2. Procédé selon la revendication 1, dans lequel chacune des tensions directes est mesurée à travers le photodétecteur en appliquant un courant d'excitation non opérationnel au photodétecteur.

3. Procédé selon la revendication 2, dans lequel le courant d'excitation non opérationnel appliqué au photodétecteur est compris entre environ 100 µA et environ 1 mA.

4. Procédé selon la revendication 1, dans lequel avant, pendant ou après la mesure de chaque photocourant induit, le procédé comprend en outre l'application d'un courant d'excitation non opérationnel à la première DEL et la mesure d'une tension directe qui se crée à travers l'anode et la cathode de la première DEL.

5. Procédé selon la revendication 4, dans lequel le courant d'excitation non opérationnel appliqué à la première DEL est compris entre environ 0,1 mA et environ 10 mA.

6. Procédé selon la revendication 1, comprenant en outre :
le fait de soumettre (18) la première DEL à une seconde température ambiante, qui est différente de la première température ambiante ; et
la répétition (20) des étapes d'application successive d'au moins trois courants d'excitation différents à la première DEL, l'obtention d'une pluralité de mesures optiques à partir de l'éclairage produit par la première DEL à chacun des au moins trois courants d'excitation différents, l'obtention d'une pluralité de mesures électriques à partir du photodétecteur, et le stockage de résultats des étapes d'obtention pour étalonner la première DEL à la seconde température ambiante.

7. Procédé selon la revendication 6, dans lequel le dispositif d'éclairage comprend une pluralité de DEL comprenant la première DEL, et dans lequel le procédé est exécuté pour chacune de la pluralité de DEL.

8. Procédé selon la revendication 1, dans lequel les au moins trois courants d'excitation différents comprennent un premier courant d'excitation opérationnel qui est sensiblement égal à un courant d'excitation maximal associé à la première DEL, un deuxième courant d'excitation opérationnel qui est sensiblement inférieur au premier courant d'excitation opérationnel, et un troisième courant d'excitation opérationnel qui est sensiblement inférieur au deuxième courant d'excitation opérationnel.

9. Procédé selon la revendication 1, dans lequel le dispositif d'éclairage comprend un photodétecteur supplémentaire, dans lequel le procédé comprend en outre l'obtention d'une pluralité de mesures électriques à partir du photodétecteur supplémentaire, dans lequel la pluralité de mesures électriques comprend une pluralité de photocourants, qui sont induits sur le photodétecteur supplémentaire par l'éclairage produit par la première DEL à chacun des au moins trois courants d'excitation différents, et une pluralité de tensions directes qui sont mesurées à travers le photodétecteur supplémentaire avant, pendant ou après la mesure de chaque photocourant induit.

10. Procédé selon la revendication 9, dans lequel la première DEL est une DEL convertie au phosphore, dans lequel la pluralité de photocourants induits sur le photodétecteur par l'éclairage produit par la DEL convertie au phosphore correspond à une première partie d'un spectre de la DEL convertie au phosphore, dans lequel la pluralité de photocourants induits sur le photodétecteur supplémentaire par l'éclairage produit par la DEL convertie au phosphore correspond à une seconde partie du spectre de la DEL convertie au phosphore, et dans lequel la première partie et la seconde partie comprennent des longueurs d'onde en crête sensiblement différentes.
